(19) Europäisches Patentamt
European Patent Office
Office européen des brevets

(11) **EP 1 547 162 B1**

(12) **EUROPÄISCHE PATENTSCHRIFT**

(45) Veröffentlichungstag und Bekanntmachung des Hinweises auf die Patenterteilung:
**04.03.2015 Patentblatt 2015/10**

(21) Anmeldenummer: **03750322.4**

(22) Anmeldetag: **05.09.2003**

(51) Int Cl.:
**H01L 33/00** *(2010.01)*

(86) Internationale Anmeldenummer:
**PCT/DE2003/002954**

(87) Internationale Veröffentlichungsnummer:
**WO 2004/032247 (15.04.2004 Gazette 2004/16)**

(54) **HALBLEITERBAUELEMENT UND VERFAHREN ZUR HERSTELLUNG**

SEMICONDUCTOR COMPONENT AND PRODUCTION METHOD

COMPOSANT A SEMI-CONDUCTEUR ET PROCEDE DE PRODUCTION ASSOCIE

(84) Benannte Vertragsstaaten:
**DE**

(30) Priorität: **30.09.2002 DE 10245631**

(43) Veröffentlichungstag der Anmeldung:
**29.06.2005 Patentblatt 2005/26**

(73) Patentinhaber: **OSRAM Opto Semiconductors GmbH**
**93055 Regensburg (DE)**

(72) Erfinder:
 • **EISERT, Dominik**
  **93049 Regensburg (DE)**
 • **ILLEK, Stefan**
  **93093 Donaustauf (DE)**
 • **SCHMID, Wolfgang**
  **95053 Regensburg (DE)**

(74) Vertreter: **Epping - Hermann - Fischer Patentanwaltsgesellschaft mbH**
**Schloßschmidstraße 5**
**80639 München (DE)**

(56) Entgegenhaltungen:
EP-A- 0 184 117    WO-A-01/41225
DE-A- 10 040 448   DE-A- 19 905 517
US-A- 4 862 239    US-A1- 2001 004 534
US-A1- 2001 050 376  US-A1- 2002 137 244
US-A1- 2003 183 835  US-B1- 6 335 546

• NAOKI WADA ET AL: "STABLE OPERATION OF ALGAAS/GAAS LIGHT-EMITTING DIODES FABRICATED ON SI SUBSTRATE" JAPANESE JOURNAL OF APPLIED PHYSICS, PUBLICATION OFFICE JAPANESE JOURNAL OF APPLIED PHYSICS. TOKYO, JP, Bd. 31, Nr. 2A PART 2, 1. Februar 1992 (1992-02-01), Seiten L78-L81, XP000277802 ISSN: 0021-4922
• WADA N ET AL: "GAAS/ALGAAS LIGHT EMITTERS FABRICATED ON UNDERCUT GAAS ON SI" JAPANESE JOURNAL OF APPLIED PHYSICS, PUBLICATION OFFICE JAPANESE JOURNAL OF APPLIED PHYSICS. TOKYO, JP, Bd. 33, Nr. 3A, PART 1, 1. März 1994 (1994-03-01), Seiten 1268-1274, XP000595069 ISSN: 0021-4922
• OLSEN G H ET AL: "Calculated stresses in multilayered heteroepitaxial structures" JOURNAL OF APPLIED PHYSICS, JUNE 1977, USA, Bd. 48, Nr. 6, Seiten 2543-2547, XP002283181 ISSN: 0021-8979

## Beschreibung

Die Erfindung betrifft ein Halbleiterbauelement und ein Verfahren zur Herstellung eines Halbleiterbauelements mit einer lichtemittierenden Halbleiterschicht oder einem lichtemittierenden Halbleiterelement und zwei Kontaktstellen, die als eine Kontaktschicht und ein Kontakt ausgebildet sind.

Ein solches Bauelement ist beispielsweise aus Wada et. al., Jpn. Appl. Phys. Vol. 31 (1992) pp. L78-L81 bekannt. Ein weiteres ist aus der DE 100 40 448 A1 bekannt. Dort wird ein Halbleiterchip mit beidseitigen Kontaktstellen und einer Verstärkungsschicht beschrieben, welches durch eine dicke Kontaktschicht und die Verstärkungsschicht ausreichend verstärkt ist, dass zur mechanischen Stabilisierung des Chips kein Trägerkörper nötig ist. Eine flächendeckende Hilfsträgerschicht, die selektiv gegenüber der Verstärkungsschicht entfernt werden kann, wird zusätzlich auf die Verstärkungsschicht aufgebracht. Die selektive Entfernung der Hilfsträgerschicht ermöglicht die Vereinzelung der Chips ohne Sägeprozeß.

Nachteilig an derartigen Bauelementen ist die Empfindlichkeit des Bauelements gegen wechselnde Temperaturen während des Herstellungsprozesses und im Betrieb. Diese führen zu thermischen Spannungen zwischen der relativ empfindlichen Halbleiterschicht und dem Trägerkörper, der üblicherweise einen höheren Ausdehnungskoeffizienten hat, als die Halbleiterschicht. Bei Erwärmung dehnt das Trägersubstrat sich stärker aus als der Halbleiter und als Folge biegt sich das Bauelement auf. Solche thermischen Spannungen können Risse im Halbleiter verursachen, was zum Ausfall des Bauelements führt.

Aufgabe der vorliegenden Erfindung ist es daher, ein Halbleiterbauelement der eingangs genannten Art zu entwickeln, das die thermischen Spannungen zwischen der Halbleiterschicht und dem Trägerkörper oder -substrat zumindest verringert und ein Verfahren zur Herstellung von Halbleiterbauelementen (einschließlich der oben genannten Art aber nicht darauf eingeschränkt) anzugeben, bei dem eine schnellere Fertigung des Bauelements und ein zuverlässigeres Endprodukt erreicht wird.

Diese Aufgabe wird durch ein Halbleiterbauelement mit den Merkmalen des Anspruchs 1 und ein Verfahren mit den Merkmalen der Ansprüche 14 und 15 gelöst. Vorteilhafte Ausgestaltungen der Erfindung gehen aus weiteren Ansprüche hervor.

Erfindungsgemäß weist ein Halbleiterbauelement mit einer lichtemittierenden Halbleiterschicht und zwei elektrischen Kontaktstellen ein vertikal strukturiertes Trägersubstrat auf. Das strukturierte Trägersubstrat ist so gestaltet, dass insbesondere durch Temperaturunterschiede entstandene Spannungen im Bauelement zumindest teilweise kompensiert werden.

In einer bevorzugten Ausführungsform weist das Trägersubstrat vertikale Strukturelemente und einen Trägerboden auf. Die vertikalen Strukturelemente stehen auf dem Trägerboden und sind voneinander durch Zwischenräume getrennt. Die vertikalen Strukturelemente verbinden den Trägerboden mit der Halbleiterschicht bzw. der Kontaktschicht oder einer Benetzungsschicht. Dehnt sich das Trägersubstrat nun stärker aus als der Halbleiter, kann der Dehnungsunterschied durch Verbiegung der Strukturelemente ausgeglichen werden. Zwar wird sich auch die Halbleiterschicht durchbiegen, allerdings wird sie nicht mehr so stark auf Zug beansprucht wie es bei einem homogenen, unstrukturierten Trägersubstrat der Fall wäre.

Das Trägersubstrat ist vorzugsweise einstückig gebildet. Unter einstückig wird bezüglich des Trägersubstrats insbesondere verstanden, dass das Trägersubstrat nicht aus verschiedenen Schichten gebildet ist oder dass das Trägersubstrat eine möglichst homogene Zusammensetzung aufweist.

Vorteilhafterweise können die Zwischenräume mit einem Füllmaterial befüllt werden, das elastischer als das Trägersubstrat-Material ist. Dies verbessert die Stabilität des Bauelements, ohne dass die Fähigkeit des strukturierten Trägersubstrats, thermische Spannungen aufzufangen, beeinträchtigt wird.

Eine weitere bevorzugte Ausführungsform weist ein einzelnes vertikales Strukturelement auf, das unter dem Zentrum von Halbleiterschicht oder -element angeordnet ist. Dieses Strukturelement dient als stabiler Kern des Bauelements und ist im Querschnitt parallel zum Trägerboden in der Größe so eingeschränkt, dass thermische Verspannungen noch nicht zu Ausfällen führen. Der Außenraum um das einzelne Strukturelement wird mit einem weicheren bzw. elastischeren Material aufgefüllt, das die thermischen Verspannungen aufnehmen und zusätzlich die Wärme aus dem Halbleiterelement abführen kann.

In den obigen Ausführungsformen können die thermischen Spannungen zusätzlich durch Auswahl eines Trägersubstratmaterials, dessen Ausdehnungskoeffizienten möglichst nah an dem der Halbleiterschicht liegt, verringert werden.

In einer weiteren Ausführungsform weist das Trägersubstrat eine Mehrschichtstruktur auf. Diese Schichtenfolge besteht aus Materialien, die unterschiedliche Ausdehnungskoeffizienten und Elastizitätsmodul aufweisen. Zumindest eine zusätzliche Trägersubstrat-Schicht wird auf die Unterseite des ersten Trägersubstrats aufgebracht bzw. laminiert, um den Zug auf der Oberseite des ersten Trägersubstrats zu kompensieren. Die Oberseite des ersten Trägersubstrats liegt näher an der Halbleiterschicht als die Unterseite. Da die Schichten fest miteinander verbunden sind, müssen sie sich auf dieselbe Länge ausdehnen. Aufgrund der unterschiedlichen Ausdehnungskoeffizienten des Halbleiters und des Trägersubstrats und daher der unterschiedlichen Längenausdehnung entstehen bei Erwärmung Biegemomente um eine neutrale Achse des Schichtpakets. Um eine Durchbiegung zu vermindern, sind die Schichten in der Dicke so aufeinander abzustimmen, dass die Biegemomente jeder Schicht einschließlich der Halbleiterschicht sich nahezu auf Null addieren, d.h. die Biegemomente müssen sich aufheben. Als Bedingung für Planarität gilt die folgende Regel:

$$0 \;=\; \sum\; z_i\; E_i\; d_i\; \alpha_i\; T$$

wobei

$z_i$ der Abstand zwischen der neutralen Achse und Element i,
$E_i$ der Hooke'sche Elastizitätsmodul des Elements i,
$d_i$ die Dicke des Elements i,
$\alpha_i$ der thermische Ausdehnungskoeffizient des Elements i und
T die Temperatur des Bauelements ist.

In der Praxis reicht es auch aus, wenn die Gleichung sich nahezu auf Null summiert, nämlich:

$$0 \;\cong\; \sum\; z_i\; E_i\; d_i\; \alpha_i\; T$$

Das erfindungsgemäße Verfahren zur Herstellung eines Halbleiterbauelements weist im wesentlichen die folgenden Verfahrensschritte auf:

(a) Epitaktisches Abscheiden einer lichtemittierenden Halbleiterschicht auf einem Wachstumssubstrat,

(b) Versehen der Halbleiterschicht mit einer metallischen Kontaktschicht,

(c) Erzeugen einer Haft- und Benetzungsschicht zumindest über der metallischen Kontaktschicht,

(d) Aufbringen, Erzeugen oder Abscheiden eines mechanisch stabilen Trägersubstrats auf der Haft- und Benetzungsschicht,

(e) Trennen der Halbleiterschicht von dem Wachstumssubstrat,

(f) Ätzen von Mesagräben zur Definition von einzelnen Chips zwischen den Mesagräben, wobei die Mesagräben zumindest durch die gesamte Halbleiterschicht und die gesamte Kontaktschicht hindurchreichen,

(g) Aufbringen eines elektrischen Kontaktes auf der Halbleiterschicht und

(h) Vereinzeln der Chips durch Trennung entlang den Mesagräben.

In einer weiteren Ausführungsform wird der Verfahrensschritt (f) vor dem Verfahrensschritt (c) durchgeführt.

Die Erzeugung oder das Abscheiden eines mechanisch stabilen Trägersubstrats auf der Haft- und Benetzungsschicht gemäß Verfahrensschritt (d) wird vorzugsweise mittels eines galvanischen Verfahrens durchgeführt. Dies hat den Vorteil, dass kleine Unebenheiten in der Oberfläche der Benetzungsschicht ausgeglichen werden können, ohne Probleme mit der Haftung darzustellen.

Bei herkömmlichen Verbindungstechniken können solche Unebenheiten Probleme bereiten. Das Aufbringen des Trägersubstrats mittels Van der Waals-Bonding erfordert zum Beispiel extrem glatte Oberflächen, damit die atomaren Kräfte wirken können. Dagegen kann Kleben zwar größere Höhenunterschiede ausgleichen, erfordert aber doch meist organische Materialien, die nicht temperatur- oder lösemittelbeständig sind. Außerdem haben solche Materialien eine geringe Leitfähigkeit für Wärme und elektrischen Strom.

Lötverfahren zum Aufbringen des Trägersubstrats haben keine der oben genannten Probleme, sind aber gegen Verunreinigungen empfindlich. Eine Störung in der Benetzungsschicht kann zum Beispiel dazu führen, dass das Lot an dieser Stelle nicht haftet und sich zurückzieht. Ebenso bewirken größere Fremdpartikel, dass das Lot den Spalt nicht vollständig auffüllen kann. Der betroffene Bereich kann dabei viel größer als der Partikel sein. Störungen in dem Gefüge des Lots sind eine weitere mögliche Fehlerquelle. Diese sind durch die Metallurgie des Lots bedingt und in Prinzip nicht schädlich, wenn die Struktur insbesondere beim Abtrennen des Wachstumssubstrats nicht stark und ungleichmäßig mechanisch oder thermisch belastet wird. Solche Belastungen treten nicht bei den herkömmlichen III/V-Materialsystemen auf, weil das Wachstumssubstrat nasschemisch durch Ätzen entfernt werden kann.

Dagegen kommen bei Halbleitern aus Nitriden bisher nur Abtrennenverfahren mit hoher thermischer (z. B. Laserliftoff) und mechanischer (z. B. Riss-Trennen) Belastung zur Anwendung. In solchen Fällen wird die Lotverbindung zwischen der Halbleiterschicht und dem Trägersubstrat stärker beansprucht und ist daher für die oben genannten Probleme anfällig. Beim mechanischen Trennen kann der Fall auftreten, dass eine Schwächung der Lotverbindung einen parasitären Rissverlauf in der Lotschicht induzieren und damit die Haftung des Halbleiters auf dem Trägersubstrat beeinträchtigen kann. Beim Laserliftoff wird an der Grenzfläche zwischen Wachstumssubstrat und Nitrid der Halbleiter (das Nitrid) durch den Laserbeschuss thermisch lokal zersetzt. Dabei entstehende überschüssige Wärme muss durch den Halbleiter und die Bondschicht abgeführt werden. Unterbrechungen im Lot führen allerdings zu einem erhöhten Wärmewiderstand und damit zu einer lokalen Überhitzung. Mögliche Folgen reichen von thermischer Schädigung des Halbleiters bzw. des Kontakts zur Rissbildung oder Delamination aufgrund der unterschiedlichen thermischen Ausdehnungskoeffizienten oder lokalem Aufschmelzen des Lotes. Aus diesen Gründen ist das galvanische Aufbringen des Trägersubstrats ohne die Erfordernis einer Lotschicht besonders vorteilhaft für Nitrid-basierte Halbleiterbauelemente.

Merkmale von vorteilhaften Weiterbildungen ergeben sich aus den Unteransprüchen.

Im folgenden wird die Erfindung anhand von Ausführungsbeispielen in Verbindung mit den Figuren 1 bis 13 näher erläutert.

Es zeigen

Figur 1 eine schematische Schnittdarstellung eines ersten Ausführungsbeispiels eines erfindungsgemäßen Bauelements,

Figuren 2a und b jeweils eine schematische Schnittdarstellung eines Bauelements unter thermischen Verspannungen und eine schematische Schnittdarstellung eines durchgebogenen Wafers,

Figuren 3a, b und c jeweils eine schematische Schnittdarstellung eines zweiten Ausführungsbeispiels eines erfindungsgemäßen Bauelements unter unterschiedlichen Betriebsbedingungen,

Figur 4 eine schematische Schnittdarstellung eines dritten Ausführungsbeispiels eines erfindungsgemäßen Bauelements,

Figur 5 eine schematische Schnittdarstellung eines vierten Ausführungsbeispiels eines erfindungsgemäßen Bauelements,

Figuren 6a und b jeweils eine schematische Schnittdarstellung eines fünften Ausführungsbeispiels eines erfindungsgemäßen Bauelements unter verschiedenen Betriebsbedingungen,

Figuren 7a bis 7g schematische Schnittdarstellungen einiger Verfahrensschritte eines ersten Ausführungsbeispiels eines erfindungsgemäßen Verfahrens,

Figur 8 eine schematische Schnittdarstellung eines sechsten Ausführungsbeispiels eines erfindungsgemäßen Bauelements,

Figuren 9a bis 9f schematische Schnittdarstellungen einiger Verfahrensschritte eines zweiten Ausführungsbeispiels eines erfindungsgemäßen Verfahrens,

Figuren 10a bis 10g schematische Schnittdarstellungen einiger Verfahrensschritte eines dritten Ausführungsbeispiels eines erfindungsgemäßen Verfahrens,

Figuren 11a bis 11d schematische Schnittdarstellungen einiger Verfahrensschritte eines vierten Ausführungsbeispiels eines erfindungsgemäßen Verfahrens,

Figuren 12a und 12b jeweils in schematischer Schnittdarstellung ein Montageverfahren des vierten verfahrensmäßigen Ausführungsbeispiels und

Figuren 13a und 13b schematische Schnittdarstellungen einiger Verfahrensschritte eines fünften Ausführungsbeispiels eines erfindungsgemäßen Verfahrens.

Gleiche oder gleichwirkende Elemente sind in den Figuren mit denselben Bezugszeichen versehen. Insbesondere die Dicke der Schichten ist in den Figuren nicht maßstabgerecht dargestellt, um dem besseren Verständnis zu dienen.

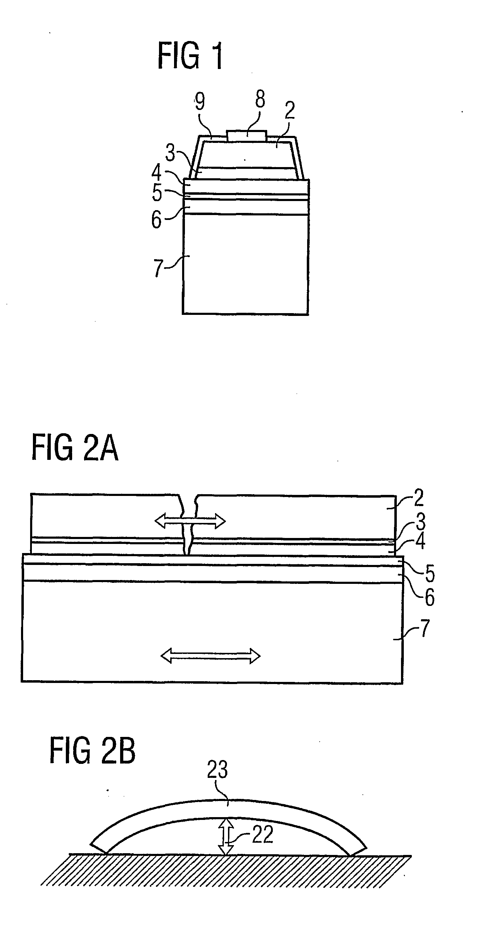

Das in Figur 1 dargestellte Halbleiterbauelement weist eine Halbleiterschicht 2, die zwischen einer Kontaktstelle 8 und einer Kontaktschicht 3 angeordnet ist. Die Kontaktschicht 3 kann auch als eine unterbrochene und/oder strukturierte Schicht ausgebildet sein, die beispielsweise mehrere kreisförmige Flächen aufweist. Beispielsweise enthält die Halbleiterschicht 2 GaN und die Kontakte 3, 8 Platin, Palladium oder Aluminium. Die Kontaktschicht 3 (weniger als ca. 5 nm dick) liegt auf einer Reflexionsschicht 4 (ca. 100nm dick), die insbesondere bei optoelektronischen Anwendungen sehr wichtig für die Lichteffizienz ist. Je nach Wellenlänge des Lichts kann die Reflexionsschicht 4 beispielsweise Gold für den roten Spektralbereich oder Silber und Aluminium für den blauen aufweisen. Kann die Reflexionsschicht durch Legierung mit anderen Metallen beeinträchtigt werden, so wird anschließend vorzugsweise eine Diffusionsbarriere 5 (beispielsweise aus TiW(N) und ca. 0,5 $\mu$m dick) auf der Reflexionsschicht 4 aufgebracht. Um bessere Haftung zu erzielen, ist die Diffusionsbarriere 5 mit einer Haft- und Benetzungsschicht 6 (beispielsweise Chrom aufweisend und ca. 1 $\mu$m dick) beschichtet. An die Benetzungsschicht 6 schließt sich ein Trägersubstrat 7 an, das ca. 50 $\mu$m dick ist und beispielsweise aus Metall, wie u. a. Nickel, Chrom, Kupfer, Wolfram besteht. Die Dicke des Trägersubstrats ist durch die erwünschte mechanische Stabilität des Bauelements und die ggf. verwendeten Maßnahmen, um die thermischen Ausdehnungen auszugleichen, bedingt. Eine Passivierungsschicht 9 bedeckt zumindest die Halbleiterschicht 2, um dies von Verunreinigungen zu schützen.

Soweit nichts anderes angegeben ist, gelten die obigen Materialien- sowie Maßangaben auch für die weiteren vorrichtungsmäßigen und verfahrensmäßigen Ausführungsbeispiele.

In Figur 2a wird mit Hilfe von Pfeilen dargestellt, wie bei Erwärmung eines bekannten Bauelements die unterschiedlichen Ausdehnungskoeffizienten des Halbleiters 2 und des Trägersubstrats 7 Spannungen im Bauelement verursachen. Da der Ausdehnungskoeffizient des Halbleiters 2 im allgemeinen geringer als der des Trägersubstrats 7 (üblicherweise ein Metall) ist, dehnt sich das Trägersubstrat 7 bei Erwärmung stärker aus als der Halbleiter. Dies kann zu Durchbiegungen während der Prozessierung sowie im Betrieb führen. Unter Umständen können diese von thermischen Spannungen verursachten Durchbiegungen wie in der Figur 2a dargestellt zum Auftritt von Rissen in der Halbleiterschicht 2 führen, was das Ausfallen des Bauelements bedeutet. In Figur 2b wird die Durchbiegung 22 des Wafers 23, nämlich die maximale Abweichung des Wafers von der Ebene, gezeigt. Um die Halbleiterschicht zu schonen und die Verarbeitbarkeit zu gewährleisten, sollte die Durchbiegung 22 auf unter 100 μm begrenzt sein. Bei GaN-Epitaxieschichten auf SiC-Substrat können massive Risse bereits auftreten, wenn die Durchbiegung 22 bei einem Wafer (Durchmesser 5 cm) 100 μm übersteigt. Ohne besondere Maßnahmen zur Verminderung der thermischen Spannungen kann eine Temperatur bedingte Beschädigung des Halbleiters 2 bereits auftreten, wenn das Trägersubstrat 7 dicker als ca. 5 μm ist. Solche Probleme tauchen sicherlich auf, wenn das Trägersubstrat 7 dicker als 15 μm ist. Deshalb sollte ein Trägersubstrat 7 ohne irgendwelche Ausgleichsmaßnahmen nicht 15 μm überschreiten. Da diese Dicke noch immer zu dünn für die während der Prozessierung erforderte mechanische Stabilität ist, muss eine oder mehrere der folgenden erfindungsgemäßen Maßnahmen ergriffen werden.

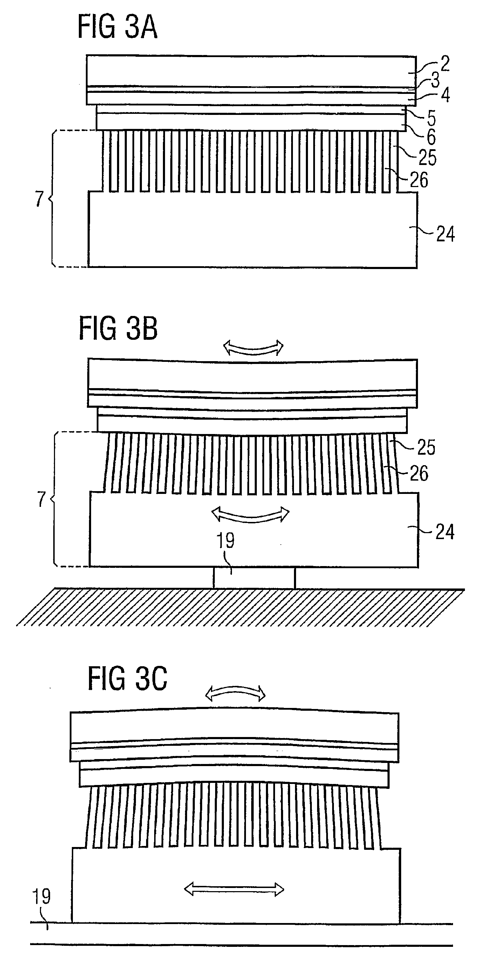

Das in Figur 3a ausgeführte Beispiel weist ein vertikal strukturiertes Trägersubstrat 7 auf, das aus einem Trägerboden 24, mehreren vertikalen Strukturelementen 25 und mehreren Zwischenräumen 26 besteht. Darauf sind in dieser Reihenfolge eine Benetzungsschicht 6, eine Diffusionsbarriere 5, eine Reflexionsschicht 4, eine Kontaktschicht 3 und eine Halbleiterschicht 2 angeordnet. Eine zweite Kontaktstelle ist hier nicht abgebildet. In diesem Beispiel weisen die Strukturelemente 25 einen kreisförmigen Querschnitt auf, können aber auch andere Formen annehmen. Die Höhe der Strukturelemente wird vorzugsweise mit der lateralen Abmessung des Halbleiters 2 skaliert, so dass das Verhältnis Halbleiterbreite zur Strukturelement-Höhe nicht den Faktor 15 überschreitet. Die Strukturelemente weisen vorzugsweise ein hohes Aspektverhältnis (d.h. Höhe/Breite) von zumindest zwei auf, damit sie sich besser verbiegen und thermische Spannungen ausgleichen können. Beispielsweise sind die Strukturelemente 5-20 μm hoch und haben einen Durchmesser von 5-10 μm. Die Dicke des Trägerbodens wird bevorzugt mindestens so dick gewählt wie die Strukturelemente hoch sind und liegt i.d.R. zwischen 20 μm und 100 μm. Die Dicke muss dem Bauelement ausreichende mechanische Stabilität während der Prozessierung und im Betrieb verleihen.

Darüber hinaus ist die Dicke eine Zeit-, Material- und letztendlich eine Kostenfrage. Die Zwischenräume 26 können mit einem während der Strukturierung eingesetzten Photolack befüllt bleiben, unbefüllt (d.h. leer) bleiben oder wie im folgenden Ausführungsbeispiel mit einem anderen Material aufgefüllt werden.

In Figur 3b wird das in Figur 3a ausgeführte Bauelement bei Erwärmung gezeigt. Das Bauelement ist mit einem sehr kleinen Teil der Trägersubstrat-Oberfläche auf einer Anschlußleiterbahn 19 befestigt. Bei Erwärmung dehnt das Trägersubstrat 7 sich mehr aus als die Halbleiterschicht 2, wobei der untere Teil der Strukturelemente 25 sich an die Ausdehnung des Trägerbodens 24 und der obere Teil sich an die Ausdehnung der Halbleiterschicht 2 anpasst. Die Strukturelemente gleichen diesen Ausdehnungsunterschied durch Verbiegung aus, so dass in diesem Beispiel die Strukturelemente sich nach innen biegen. Dies hat die Folge, dass sich die Kanten des Trägerbodens 24 und die Kanten der Halbleiterschicht 2 leicht nach oben biegen. Dies wäre auch der Fall, wenn das Bauelement bzw. das Trägersubstrat 7 nicht befestigt wäre.

Dagegen, wie in Figur 3c dargestellt, biegen sich die Kanten der Halbleiterschicht 2 nach unten, wenn das Bauelement flächig auf einer Platine oder Anschlußleiterbahn 19 befestigt ist. Hier biegt sich der obere Teil der Strukturelemente 25 auch, wie in Figur 3b dargestellt, nach innen, aber aufgrund des steifen, flächig befestigten Trägerbodens 24 bildet sich eine kleine Auswölbung der Oberfläche der Halbleiterschicht 2.

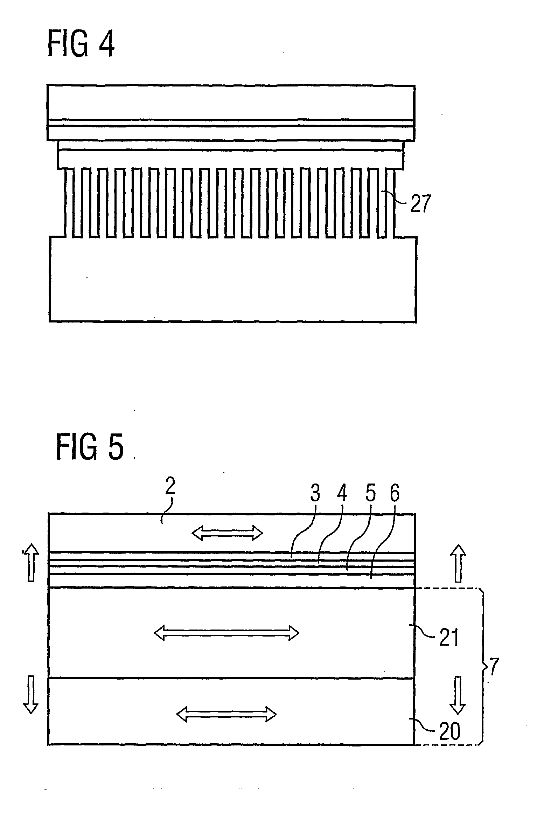

In einem weiteren Ausführungsbeispiel werden die Zwischenräume 26 des in Figur 3a dargestellten Bauelements mit einem Füllmaterial 27, das elastischer ist als das Material des Trägersubstrats 7, zur Verbesserung der Stabilität des Bauelements aufgefüllt. Dies wird in Figur 4 dargestellt. Hier bestehen die Strukturelemente 25 und Trägerboden 24 beispielsweise aus Nickel und das Füllmaterial 27 aus Gold.

Andere Materialien wie Polymere sind auch als Füllmaterial 27 denkbar.

In Figur 5 wird ein Ausführungsbeispiel dargestellt, welches noch eine Möglichkeit zur Verminderung der thermischen Biegespannungen in einem derartigen Bauelement anbietet. Das Trägersubstrat 7 des in Figur 5 dargestellten Beispiels besteht aus zwei verschiedenen Materialien mit unterschiedlichen Ausdehnungskoeffizienten und Elastizitätsmodulen. Die dünnere Trägersubstrat-Schicht 20 weist beispielsweise einen höheren Elastizitätsmodul und kleineren Ausdehnungskoeffizienten aus als die dickere Trägersubstrat-Schicht 21. Durch die Trägersubstrat-Schicht mit kleinerem Ausdehnungskoeffizienten 20 und die Dicke der Schichten wird der Zug des Trägersubstrats 7 an der Halbleiterschicht 2 teilweise kompensiert. Beispielsweise besteht die obere Trägersubstrat-Schicht 21 aus Kupfer mit einer Dicke von 50 μm und die untere 20 aus Wolfram mit einer Dicke von 1,3 μm oder Chrom mit einer Dicke von 2,7 μm. Mehr als zwei verschiedene Materialien können auch vorgesehen sein. Die zweite Kontaktstelle 8 und eine eventuelle Passivierungsschicht 9 sind nicht hier abgebildet.

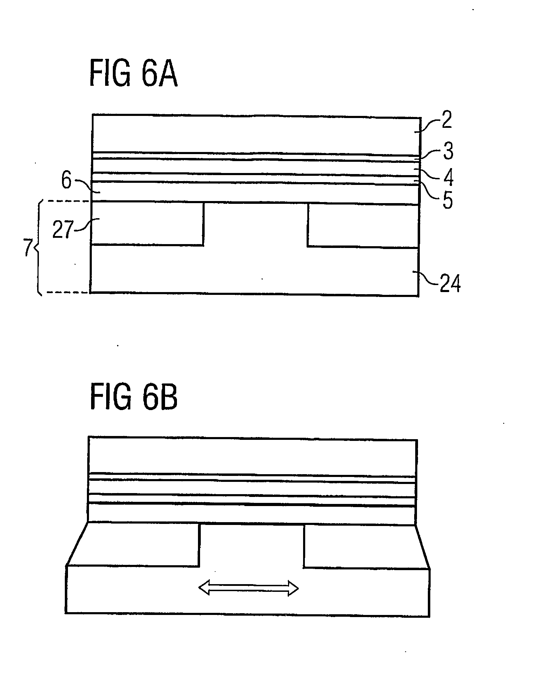

In Figur 6a wird eine Abwandlung des in Figur 4 gezeigten Bauelements dargestellt. Das Trägersubstrat 7 weist hier ein einziges vertikales Strukturelement 25 aus, das zentral bzw. mittig unter der Halbleiterschicht 2 angeordnet ist, d.h. zentriert zur Halbleiterschicht 2. Dieses Strukturelement 25 bildet dadurch einen stabilen Kern für das Bauelement und ist in der Größe so eingeschränkt, dass thermische Verspannungen noch nicht zu Ausfällen führen. Beispielsweise ist dieses Strukturelement 25 im Querschnitt kreisförmig und hat einen Durchmesser von ca. 100 $\mu$m, wenn das Bauelement einen Durchmesser von ca. 300 $\mu$m hat. Andere Formen und Größen des Strukturelements 25 sind auch denkbar. Der verbleibende Außenraum ist mit einem weicheren Material aufgefüllt, das die thermischen Verspannungen aufnehmen kann. Wie oben zu Figur 4 beschrieben, eignet sich beispielsweise Nickel für das Strukturelement 25 und Trägerboden 24 und Gold für das Füllmaterial 27. Das Füllmaterial 27 sollte aber immer noch die Wärme aus dem Bauelement abführen können.

Figur 6b zeigt das in Figur 6a dargestellte Bauelement unter thermischer Verspannungen. Hier wird die Halbleiterschicht viel weniger beansprucht als das in Figur 1 dargestellte Bauelement, weil eine kleinere Grenzfläche zwischen dem stärker ausgedehnten Trägersubstrat und der Halbleiterschicht beansprucht ist und daher nur ein Bruchteil der Verspannungen, die das in Figur 1 dargestellten Bauelement spürt, schädlich auf die Halbleiterschicht 2 wirken kann. Das Füllmaterial 27 passt sich sowohl der Ausdehnung des Trägersubstrats 7 als auch der Ausdehnung der Halbleiterschicht 2 an.

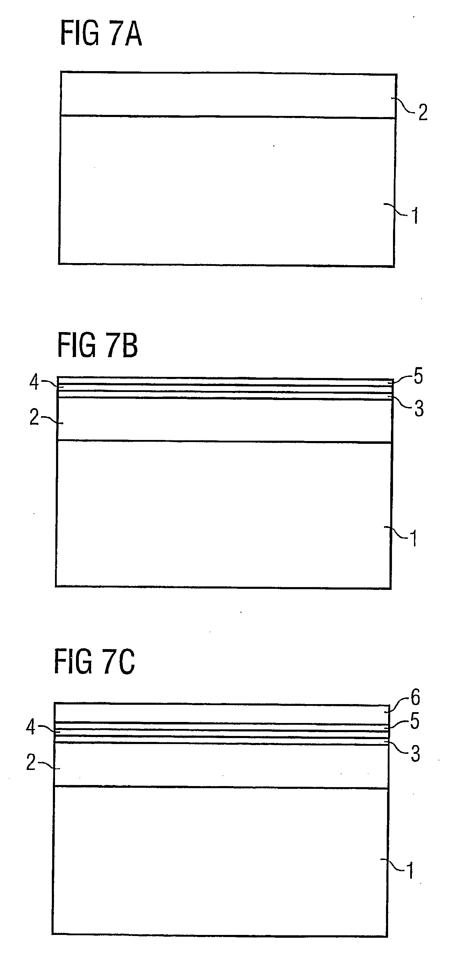

In den Figuren 7a bis g wird der schematische Ablauf des Verfahrens zur Herstellung des in Figur 1 dargestellten, erfindungsgemäßen Bauelements gezeigt. Die gewünschte Halbleiterschicht 2 wird epitaktisch auf einem Wachstumssubstrat 1 abgeschieden (s. Figur 7a). In diesem Beispiel wird GaN epitaktisch auf Saphir abgeschieden.

Wie in Figur 7b dargestellt, wird die Halbleiterschicht 2 danach mit einer Kontaktschicht 3 vorzugsweise mittels Aufdampfens oder Sputterns versehen. Da die später aufgebrachten Schichten nicht lichtdurchlässig sind, sollte diese Schicht bei optoelektronischen Bauteilen gut reflektierend sein. Oft ist aber der Kontakt der Spiegelmetallisierung zur Halbleiterschicht 3 schlecht. Deshalb kann eine zusätzliche Reflexionsschicht 4 auf die Kontaktschicht 3 aufgebracht werden, wobei die Kontaktschicht 3 durch sehr dünne semitransparente oder mit Löchern versehene Schichten aus besser elektrisch leitenden Kontaktmetallen ausgebildet wird, so dass sie wenig Licht absorbiert. Kann der Spiegel durch Legierung mit anderen Metallen zerstört werden, sollte anschließend eine Diffusionsbarriere 5 auf die Reflexionsschicht 4 aufgebracht werden. Das Aufbringen der Reflexionsschicht 4 und/oder Diffusionsbarriere 5 kann mittels Aufdampfens oder Sputterns erfolgen.

Als oberste Schicht wird eine Haft- und Benetzungsschicht 6 auf die Diffusionsbarriere 5 aufgebracht. Diese wird vorzugsweise mittels Aufdampfens oder Sputterns aufgebracht und kann aus Chrom, Nickel oder leitfähigem TiO bestehen. (Siehe Figur 7c.)

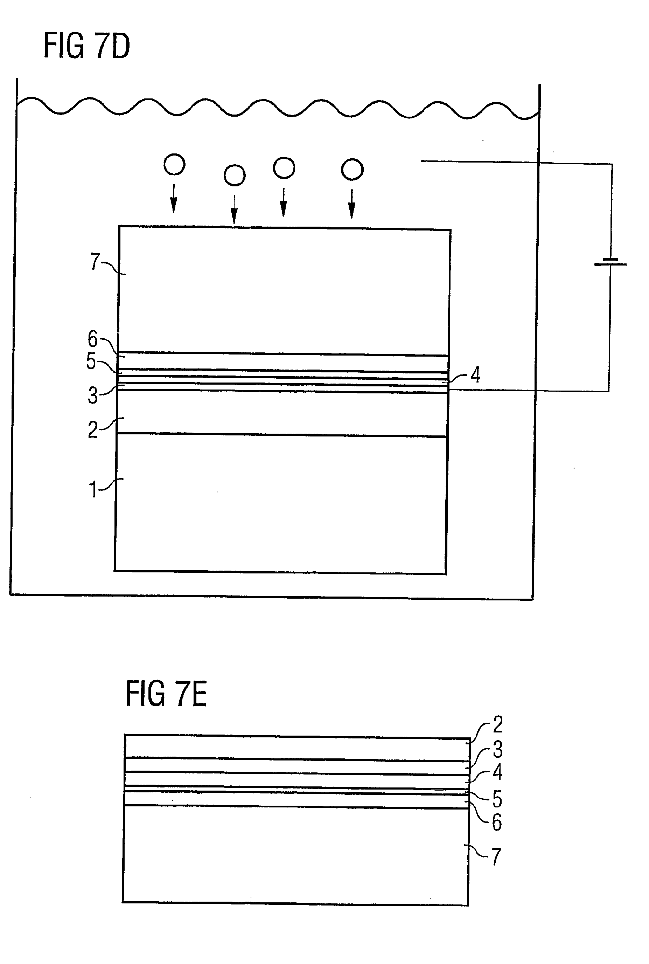

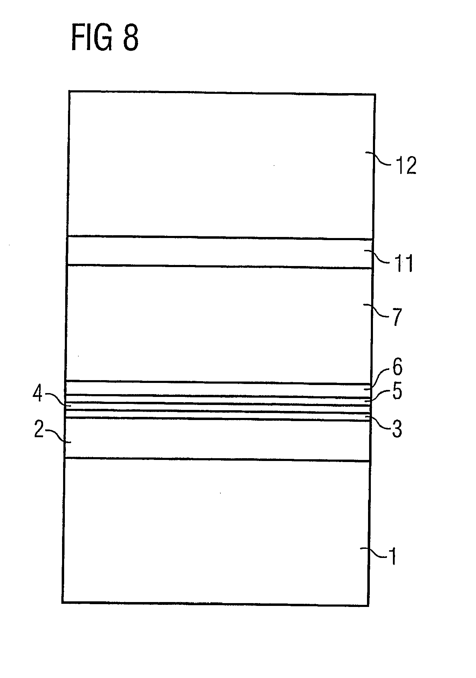

Auf der Haft- und Benetzungsschicht 6 wird ein Trägersubstrat 7 bis zur gewünschten Dicke beispielsweise mittels Sputterns, eines CVD-Verfahrens (nämlich eines Chemical Vapor Deposition-Verfahrens), eines galvanischen Verfahrens, stromloses Plattieren oder eines anderen bekannten Verfahrens abgeschieden. Siehe Figur 7d. Die Dicke des Trägersubstrats richtet sich im wesentlichen nach der während der Prozessierung und im Betrieb benötigten, mechanischen Stabilität, den maximal erlaubten thermischen Spannungen, bevor Risse im Halbleiter auftreten, und danach, ob Maßnahmen wie das Einbauen eines Hilfssubstrats (wie unten erklärt) ergriffen worden sind. Ohne Maßnahmen, thermische Spannungen auszugleichen, sollte das Trägersubstrat nicht 15 $\mu$m in der Dicke überschreiten. Da diese Dicke zu dünn für die Prozessierung ist, kann ein Hilfssubstrat 12 eingesetzt werden. (Siehe Figur 8 und die Beschreibung dazu unten.)

Das Trägersubstrat 7 sollte aus einem Material bestehen, das thermisch und elektrisch gut leitfähig sowie mechanisch stabil ist. Unebenheiten und Fremdpartikel sollten auch durch das Trägersubstrat 7 ausgeglichen werden. Da die Abscheidung bei Raumtemperatur erfolgen kann, ist eine Interdiffusion während des Prozesses nicht zu befürchten. Vorzugsweise wird ein galvanisches Verfahren verwendet. Aufdampfen hat die Nachteile, dass die Abscheideraten relativ gering sind und die aufgebrachte Schicht geringe Festigkeit aufweist. Dagegen sind Sputterverfahren, Abscheidung aus der Gas-Phase (CVD-Verfahren) und Abscheidung aus einer flüssigen Phase besser geeignet.

Wie in Figur 8 gezeigt, kann optional auf das Trägersubstrat 7 zusätzlich noch eine Lotschicht 11 aufgebracht werden, um darauf ein weiteres Hilfssubstrat 12 zu bonden. Beispielsweise kann ein mechanisch stabiler Halbleiter wie Silizium, Germanium, Siliziumkarbid oder ein Metallsubstrat aus Molybdän oder Wolfram verwendet werden. Die Lotschicht 11 weist beispielsweise eine Gold/Zinn-Mischung auf. Ein Hilfssubstrat 12 kann erforderlich sein, wenn die Metallschicht selber nicht zu dick sein soll, oder deren Abscheidung sehr teuer ist. Da die Lotschicht 11 sich jetzt in größerem Abstand von der Halbleiterschicht 2 befindet, beeinflussen ihre schlechten mechanischen Eigenschaften, wie oben bereits erklärt, den Trennprozeß nicht. Die Lotschicht 11 und/oder das Hilfssubstrat 12 können mittels Sputterns, Aufdampfens oder galvanisch aufgebracht werden. Nach der Entfernung des Wachstumssubstrats 1 besteht die Möglichkeit, bei Wahl eines niedrigschmelzenden Lots das Hilfssubstrat 12 wieder zu entfernen und in den Prozeß zurückzuführen oder gegen ein anderes (z.B. billigeres aus Aluminium oder Kupfer) auszutauschen. Außerdem kann das Hilfssubstrat 12 auch mittels eines Klebeverfahrens (z.B. NanoPierce®, siehe http://www.nanopierce.com) befestigt werden.

Nach dem Aufbringen des Trägersubstrats und eventuell des Hilfssubstrats wird das Wachstumssubstrat 1 von der Halbleiterschicht 2 getrennt. Je nach ausgewähltem Wachstumssubstrat 1 und Halbleiter 2 kann dieser Prozeßschritt durch chemische Auflösung des Wachstumssubstrats 1, eine Opferschicht, ein Laser-Liftoff-Verfahren, ein mit Sollbruchstellen ausgestattetes, laminiertes Wachstumssubstrat oder ein anderes bekanntes Verfahren durchgeführt werden.

Substratmaterialien wie GaAs oder Silizium können leicht chemisch aufgelöst werden. Das Wachstumssubstrat geht dabei verloren. Zusätzlich muss der Halbleiter entweder selber inert gegen die Ätzlösung sein oder mit speziellen Ätzstoppschichten ausgerüstet werden. Eine weitere Möglichkeit ist, eine Opferschicht in die Halbleiterschicht 2 einzubauen, die selektiv geätzt werden kann. Auf diese Weise geht das Wachstumssubstrat 1 nicht verloren und kann auch wieder im Prozeß eingeführt werden.

Im Materialsystem der Nitride, die für Lichterzeugung im kurzwelligen Spektralbereich verwendet werden, sind bislang keine geeigneten chemischen Ätzverfahren sowohl für gängige Substrate wie Saphir oder Siliziumkarbid als auch Halbleiter (wie AlN, GaN, InN) bekannt. Zum Abtrennen der Halbleiterschicht 2 wird daher hier beispielsweise das Verfahren des Laser-Liftoffs eingesetzt. Dabei wird ausgenutzt, dass sich GaN bei Beschuss mit einem Laser in Gallium und gasförmigen Stickstoff zersetzen kann. Es wird ein Laser mit einer Photonenenergie ausreichend für das Zersetzen des GaN, aber nicht ausreichend für das Zersetzen des Wachstumssubstrats verwendet. Der Laser wird durch den Saphir gestrahlt, der bei den benötigten Wellenlängen immer noch transparent ist. An der Grenzschicht zum Saphir wird so das GaN zersetzt und aufgrund der Entstehung der Gase und des Drucks wird die Halbleiterschicht 2 von dem Saphir-Wachstumssubstrat 1 abgetrennt. Das Bauelement nach dem Abtrennen des Wachstumssubstrats 1 ist in Figur 7e abgebildet. Allerdings ist dieses Verfahren nicht möglich bei auf SiC abgeschiedenem GaN, da SiC eine kleinere Bandlücke besitzt als GaN und daher vor GaN zersetzt wird.

Ferner besteht auch die Möglichkeit, die Halbleiterschicht 2 auf einem bereits laminierten Wachstumssubstrat 1 abzuscheiden. Ein solches laminiertes Wachstumssubstrat 1 (z.B. SMARTCUT® oder UNIBOND®) weist als oberste Schicht eine Haftschicht auf, die mit geeigneten Sollbruchstellen ausgestattet ist. An diesen Stellen wird die dünne Halbleiterschicht 2 nach dem Aufbringen des Trägersubstrats 7 von dem Wachstumssubstrat 1 getrennt.

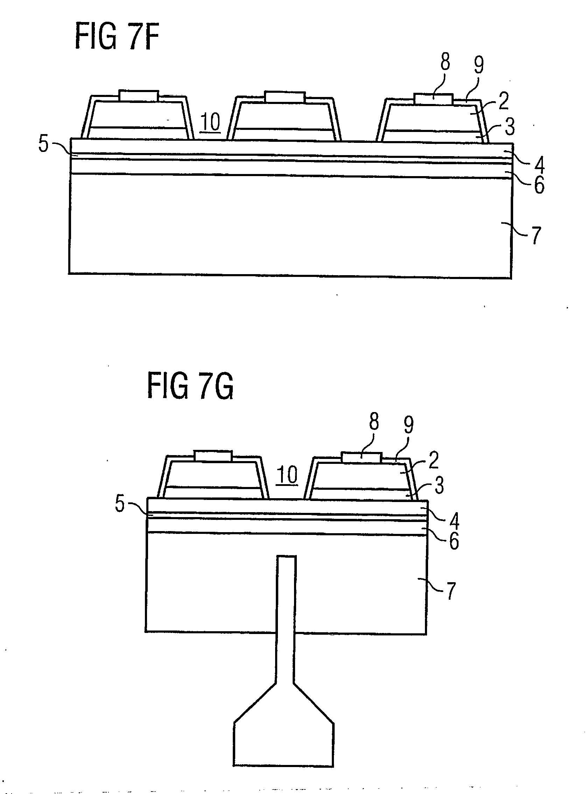

Nun werden Mesagräben 10 zumindest in die Halbleiterschicht 2 und die Kontaktschicht 3 so geätzt, dass einzelne Chips zwischen den Mesagräben 10 definiert werden. Die Mesagräben 10 reichen zumindest durch die gesamte Halbleiterschicht 2 und die Kontaktschicht 3. Die Form der Mesagräben 10 im Querschnitt ist beispielsweise in Figur 7f abgebildet. Andere Formen sind auch möglich. Das Ätzen von Mesagräben 10 kann mittels Photolithographie oder anderer bekannter Verfahren in Kombination mit Trocken-Ätzen, beispielsweise dem RIE-Verfahren (d.h. Reactive Ion Etching) durchgeführt werden.

In einem weiteren Verfahrensschritt wird gemäß Figur 7f der Kontakt 8 mittels Sputterns oder Aufdampfens auf die Halbleiterschicht 2 aufgebracht. Der Kontakt 8 enthält beispielsweise Aluminium. Eventuell kann eine Passivierungsschicht 9 (z.B. aus Siliziumnitrid oder Siliziumoxid) mittels Sputterns oder eines CVD-Verfahrens über den Teil der Halbleiterschicht 2, der nicht von dem Kontakt 8 bedeckt ist, und zumindest über die Seitenflächen der Kontaktschicht 3 aufgebracht werden.

Optional können zur Optimierung der Lichtauskopplung dreidimensionale Strukturen im Halbleiter oder in der Passivierungsschicht 9 hergestellt werden. Da das Licht zuerst aus dem Halbleiter ausgekoppelt wird, haben solche Strukturen bessere Wirkung, wenn sie in der Halbleiterschicht 2 erzeugt werden, als in der Passivierungsschicht 9. Strukturen zur Verbesserung der Lichtkopplung können aber natürlich in beiden Schichten erzeugt werden.

Beispielsweise werden Pyramidenstrukturen, die zumindest drei sichtbare Flächen je Pyramide aufweisen, in die Halbleiterschicht 2 eingeätzt, bevor die Kontakte 8 oder die eventuelle Passivierungsschicht 9 aufgebracht werden. Nachdem die Halbleiterschicht 2 von dem Wachstumssubstrat 1 abgetrennt ist, ist die Oberfläche der Halbleiterschicht 2 einigermaßen rauh.

Insbesondere durch ein anisotropisches Ätzverfahren wie ein RIE-Verfahren entstehen die Pyramidenstrukturen. Je nach ausgewähltem Halbleiter können die Strukturen aber auch mittels nasschemischen Ätzens oder Trocken-Ätzverfahren erzeugt werden. Zum Beispiel ist ein RIE- oder ICP-Verfahren (d.h. inductively coupled plasma) für die Strukturierung des GaN besser geeignet, wobei für einen GaAs-Halbleiter auch nasschemisches Ätzen verwendet werden kann. Nach einer solchen Strukturierung wird der Kontakt 8 und vorzugsweise auch eine Passivierungsschicht 9 aufgebracht, um die Oberfläche vor Verschmutzung zu schützen.

Zum Schluß werden die Chips entlang den Mesagräben 10 beispielsweise durch Sägen oder Laserschneiden vereinzelt. In der Figur 7g ist die Vereinzelung mit einem Sägeblatt dargestellt.

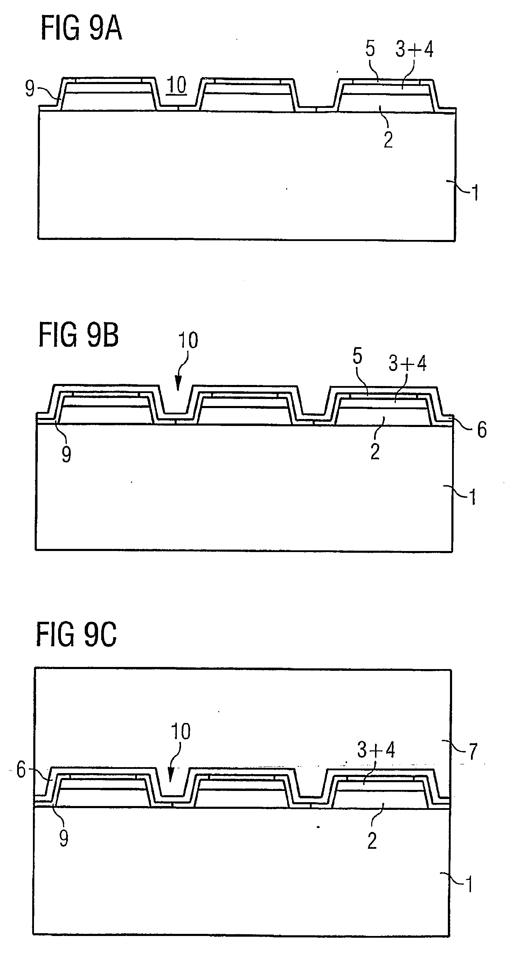

In den Figuren 9a bis 9f werden die Verfahrensschritte einer Abwandlung des in den Figuren 7a bis 7g dargestellten Verfahrens zum Teil skizziert. Die Angaben zu Materialien und Verfahren vom obigen Ausführungsbeispiel gelten auch für die folgenden Ausführungsbeispiele, soweit nichts anderes angegeben ist. Das Aufbringen der Halbleiter- 2, Kontakt- 3 und Reflexionsschicht 4 auf dem Wachstumssubstrat 1 wird nach der obigen Beschreibung zu den Figuren 7a und 7b durchgeführt. In diesem Fall wird die Reflexionsschicht 4 in der Kontaktschicht 3 integriert. Diese kombinierte Schicht wird mit der Bezeichnung 3+4 in den Figuren gekennzeichnet.

Wie in Figur 9a abgebildet, werden hier die Mesagräben 10 vor dem Trennen der Halbleiterschicht 2 von dem Wachstumssubstrat 1 in die Kontakt-/Reflexions- 3+4 und Halbleiterschicht 2 geätzt. Dies kann vorteilhaft sein, wenn der Mesaätzprozeß Probleme mit einer darunterliegenden Schicht verursacht. Zum Beispiel werden die Diffusionsbarriere 5, die Benetzungsschicht oder das Trägersubstrat 7 beim obigen Verfahren vor dem Mesaätzprozeß aufgebracht, bei diesem Verfahren aber erst nach dem Mesaätzprozeß und sind deshalb nicht dem Ätzen ausgesetzt. Nach dem Ätzen steht der Schichtstapel (nämlich die Kontakt-/Reflexions- 3+4 und Halbleiterschicht 2) in Form einzelner Inseln auf dem Wachstumssubstrat 1. Eine Diffusionsbarriere 5 wird auf diesen Inseln aufgebracht, d.h. auf die Kontakt-/Reflexionsschicht 3+4. Anschließend wird eine Passivierungsschicht 9 flächig über die nicht von der Diffusionsbarriere bedeckte Kontakt-/Reflexions- 3+4 und Halbleiterschicht 2 und über den in Mesagraben 10 befindlichen Teil des Wachstumssubstrats 1 aufgebracht.

Eine Haft- und Benetzungsschicht 6 wird auf die gesamte Oberfläche einschließlich der Oberfläche der Mesagräben 10 aufgebracht. Siehe Figur 9b.

Gemäß Figur 9c wird das Trägersubstrat 7 beispielsweise galvanisch auf die Benetzungsschicht 6 bis zur gewünschten Dicke aufgebracht, so dass die Mesagräben 10 auch gefüllt werden.

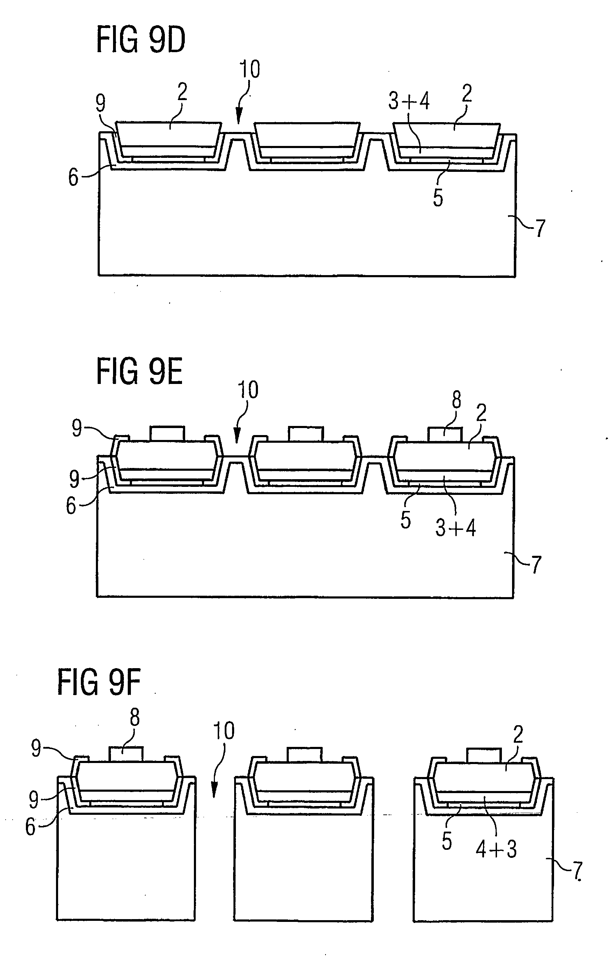

Das Wachstumssubstrat 1 wird nach einer der oben genannten Trennmethoden von der Halbleiterschicht 2 getrennt. Dabei werden die Teile der Passivierungsschicht 9, die in den Mesagräben liegen, auch entfernt. Siehe Figur 9d.

Gemäß Figur 9e werden die Kontakte 8 auf die Halbleiterschicht 2 aufgebracht. Um die Halbleiterschicht 2 besser vor Verunreinigungen zu schützen, wird die Passivierungsschicht 9 auf die Halbleiterschicht 2 erweitert.

Schließlich werden die Chips entlang den Mesagräben mittels Sägens oder Laserschneidens vereinzelt. Siehe Figur 9f.

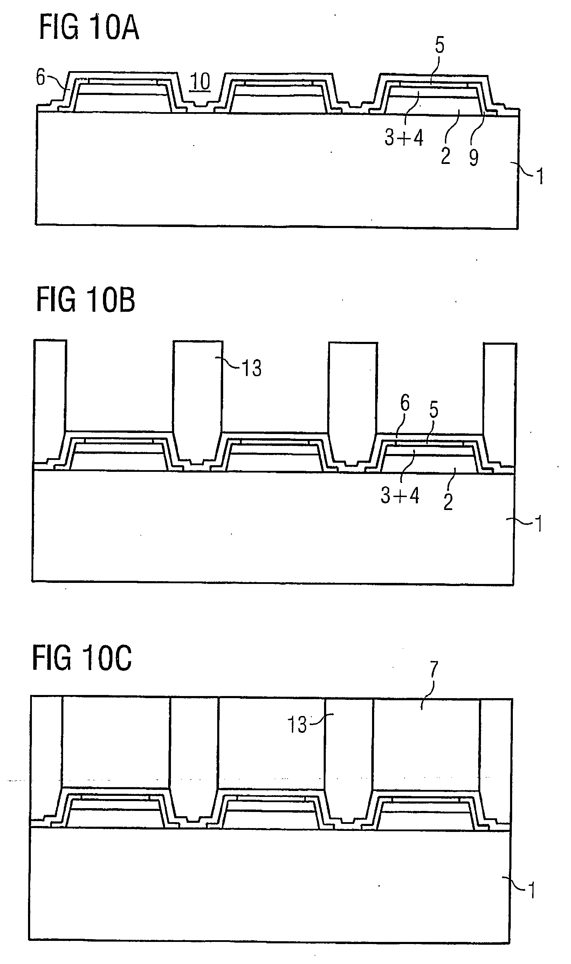

Ein weiteres verfahrensmäßiges Ausführungsbeispiel wird in den Figuren 10a bis 10g dargestellt. Dieses Verfahren schließt unmittelbar an das vorige Verfahren nach dem Aufbringen der Benetzungsschicht 6 an (vgl. Figuren 9b und 10a). Anstatt das Trägersubstrat 7 flächig wie in Figur 9c dargestellt aufzubringen, werden Trennstege 13 beispielsweise aus einem Photolack mittels Photolithographie, des LIGA-Verfahrens oder eines ähnlichen Verfahrens mit galvanischer Abformung aufgebracht. Dies wird erzielt, indem der Photolack auf die Benetzungsschicht 6 flächig bis zu mindestens 10 $\mu$m Dicke aufgebracht wird, so dass alle Mesagräben über ihre gesamte Länge auch ganz gefüllt sind. Nach geeigneter Belichtung kann der Photolack, der zwischen den Mesagräben und oberhalb der Halbleiterschicht 2 liegt, selektiv entfernt werden (siehe Figur 10b). Wichtig ist, dass dieses Material selektiv entfernt werden kann. Die Trennstege 13 können mit modernen Resistsystemen (z.B. ein LIGA-Verfahren oder einen dafür geeigneten Photolack wie den ma-P 100 oder den SU-8 von Micro-Chem Corp.) sehr hohe Aspektverhältnisse erreichen. Vorteilhaft sind möglichst schmale Trennstege. Je schmäler die Trennstege 13 sind, desto weniger nutzbare Waferfläche wird durch die Trennstege verschwendet. Dies bedeutet wiederum, dass die Anzahl der Chips pro Wafer erhöht wird und die Kosten gesenkt werden.

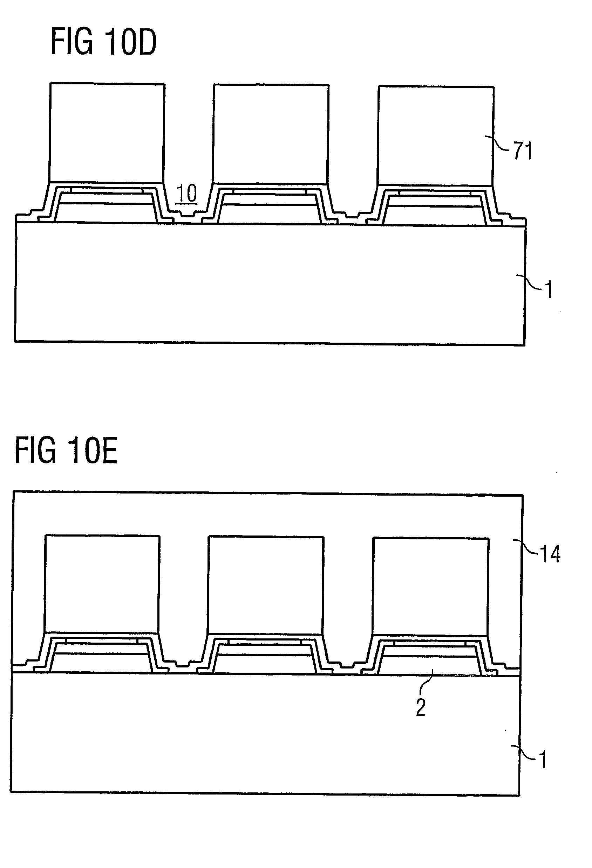

Die Zwischenräume zwischen den Trennstegen 13 oberhalb der Halbleiterschicht 2 werden nach Figur 10c beispielsweise galvanisch mit einem als Trägersubstrat 7 geeigneten Material maximal bis zur Höhe der Trennstege aufgefüllt. Dann werden die Trennstege mit Hilfe eines Lösungsmittels oder durch Ätzen selektiv entfernt. Die dadurch entstandenen Trägersubstrat-Inseln 71 werden in Figur 10d abgebildet. Zur einfacheren Handhabung für die weitere Prozessierung werden die Trägersubstrat-Inseln 71 samt Mesagräben komplett mit einem Hilfsmaterial 14 von tragfähiger Dicke überformt. Die Bauelemente nach dieser Überformung sind in Figur 10e abgebildet. Das Hilfsmaterial 14 kann durch ein Sputterverfahren, ein CVD-Verfahren, ein galvanisches Verfahren, stromloses Plattieren oder ein anderes bekanntes Verfahren aufgebracht werden. Der Einsatz von Metallen, geeigneten Polymeren (z.B. Polyimid) oder SpinOn-Gläsern ist denkbar. Mechanische Festigkeit kann auch durch Aufkleben oder Auflöten auf ein zweites Substrat verliehen werden. Wichtig ist aber, dass das Hilfsmaterial 14 wieder selektiv entfernt werden kann.

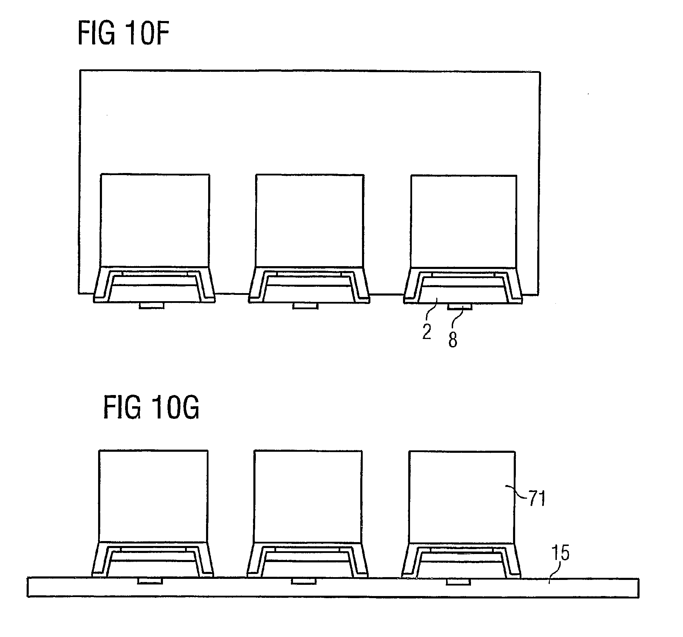

Nach der Überformung mit Hilfsmaterial 14 wird das Wachstumssubstrat 1 nach einem der bereits genannten Verfahren von der Halbleiterschicht 2 getrennt. Wie in Figur 10f gezeigt, werden die Kontakte 8 anschließend auf die Halbleiterschicht 2 aufgebracht.

Die Bauelemente können nun ohne mechanische Kraft vereinzelt werden. Eine Trägerfolie 15 wird über den Kontakten 8 auf der Halbleiterschicht aufgebracht und das Hilfsmaterial 14 wird beispielsweise durch Ätzen selektiv entfernt. Dann sind die Bauelemente automatisch vereinzelt und, wie in Figur 10g abgebildet, stehen auf einer Trägerfolie 15 bereit. Dieser Vereinzelungsprozeß kann sehr schnell sein, ausreichende Ätzraten vorausgesetzt. Anders als Sägen, für das der Zeitverbrauch einfach proportional zur Zahl der Bauelemente ist, ist der Zeitverbrauch hier unabhängig von der Anzahl der Bauelemente und der Wafergröße. Dies hat als zusätzlichen Vorteil über den Sägeprozeß, dass jegliche Geometriebeschränkungen an das Bauelement wegfallen. Es können also auch runde oder viereckige Bauelemente hergestellt werden. Durch die schmalen Trennstege 13 wird auch die Verschwendung der Waferfläche, die ungenutzt als Sägespur wegfällt, verringert.

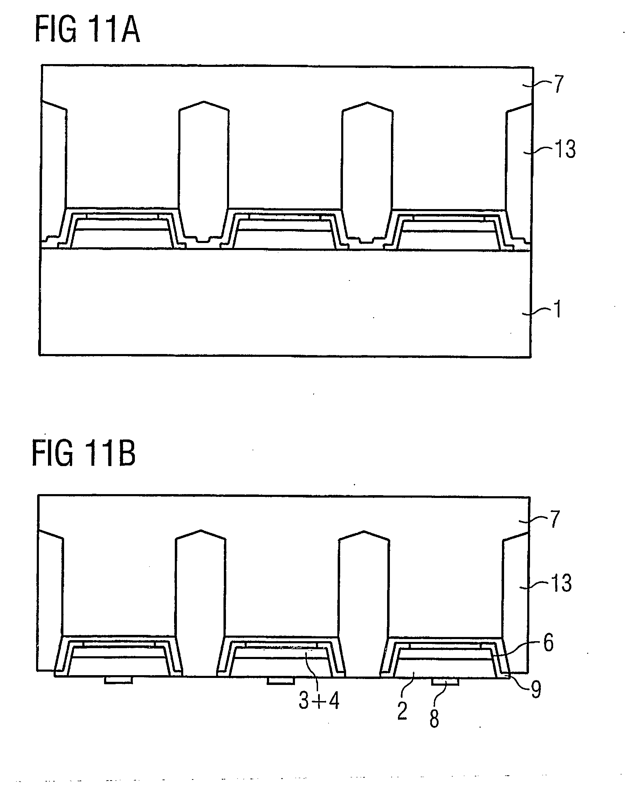

In den Figuren 11a bis 11d wird ein weiteres Ausführungsbeispiel skizziert, das eine Variation des letzten Verfahrens darstellt. Bei diesem Ausführungsbeispiel läuft das Verfahren im wesentlichen nach dem in Figuren 10a bis 10c zusammengefaßten Schema mit der Ausnahme, dass die Oberseite der Trennstege 13 im Querschnitt als eine Spitze ausgebildet ist. Anstatt eines Aufbringens des Trägersubstrats 7 nur bis zur Höhe der Trennstege 13, wird dieser Prozeß weitergeführt, so dass die ganze Struktur samt Trennstegen 13 flächig überformt ist. Dies wird in Figur 11a dargestellt und kann mit dem gleichen Material wie das für das Trägersubstrat 7 verwendete, oder mit einem anderen geschehen.

Die überformte Struktur sollte nun ausreichend tragfähig sein, dass das Wachstumssubstrat 1 ohne weiteres entfernt werden kann. Die Kontakte 8 werden auf die Halbleiterschicht 2 aufgebracht. Siehe Figur 11b.

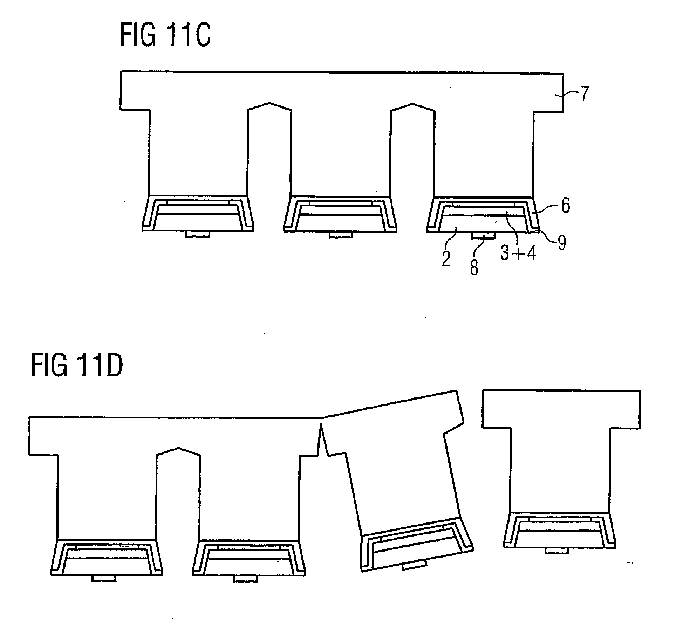

Figur 11c zeigt die Bauelemente, nachdem die Trennstege 13 beispielsweise mittels organischen Lösungsmittels von der Seite der Halbleiterschicht 2 her aufgelöst sind. Damit steht jeder Chip quasi frei auf Trägersubstrat-Inseln, die durch eine Trägersubstratschicht verbunden sind. Da die verbindende Trägersubstratschicht jetzt vergleichsweise dünn ist, können die Bauelemente, wie in Figur 11d gezeigt, mit geringer Kraft abgeschert werden. Die spitzige Form der Trennstege unterstützt den Scherprozeß und kann auch vorteilhaft bei einem Trägersubstrat-Material wirken, das eine geringe Scherfestigkeit aufweist.

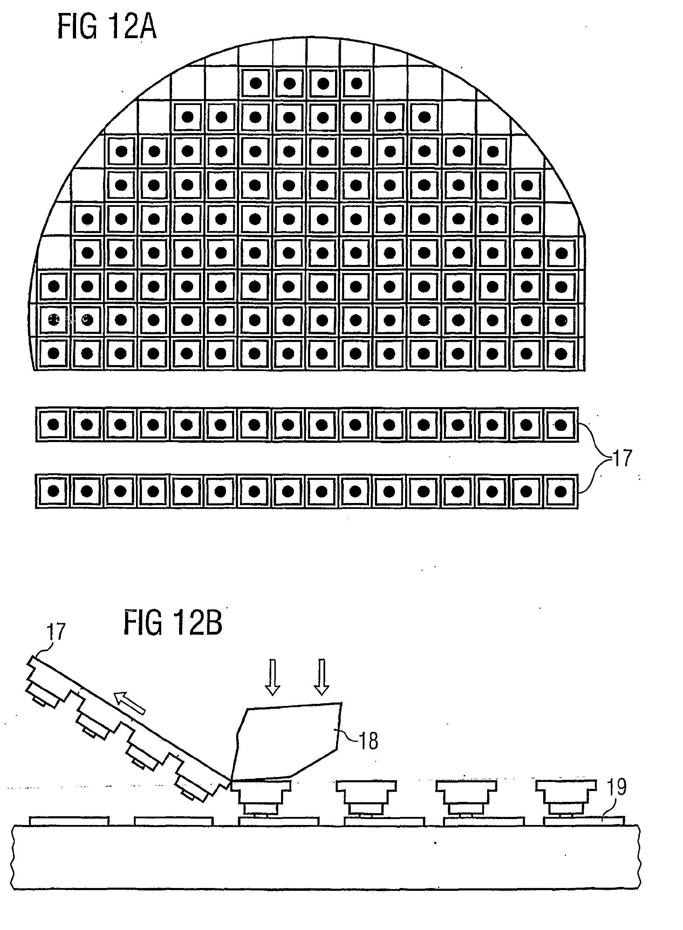

Die Figuren 12a und 12b zeigen die Unterteilung eines ganzen Wafers mit Bauelementen in Zeilen und wie die Zeilen z.B. mittels Thermokompression auf Anschlußleiterbahnen 19 befestigt werden können. Gleichzeitig reißt oder bricht eine Montagemaschine 18 die Verbindung ab und fährt zum nächsten Feld. Da dabei nur kurze Wege zurückgelegt werden, eignet sich das Verfahren auch zum Bestücken von Flächen mit größeren Stückzahlen (z.B. von selbstleuchtenden RGB-Displays).

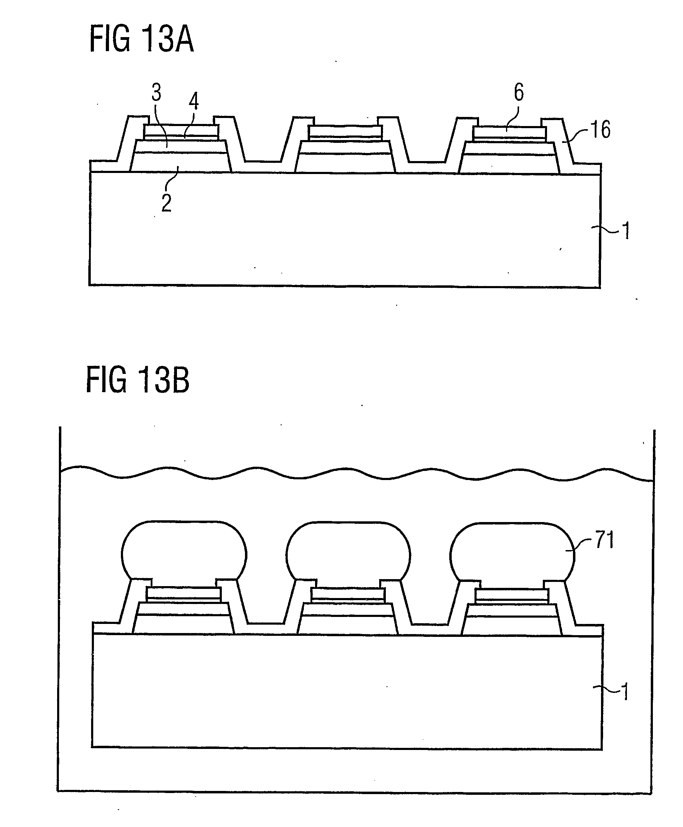

In den Figuren 13a und 13b wird ein weiteres Ausführungsbeispiel skizziert, das eine Alternative zu dem in den Figuren 10a bis 10g gezeigten Verfahren darstellt. Hier wird das Bauelement ohne Photolack und ohne Strukturierung hergestellt. Anstatt dass die Benetzungsschicht 6 wie in Figur 10a auf die gesamte Oberfläche aufgebracht wird, wird die Benetzungsschicht 6 bei diesem Ausführungsbeispiel lediglich auf die äußerste Schicht oberhalb der Halbleiterschicht 2 aufgebracht, d.h. kein benetzendes Material befindet sich auf den Seiten- oder Oberflächen der Mesagräben. Wie in Figur 13a dargestellt, wird eine Anti-Benetzungsschicht 16 auf die Seiten- und Oberflächen der Mesagräben aufgebracht. Diese Anti-Benetzungsschicht 16 kann ein Dielektrikum wie Siliziumnitrid oder Siliziumoxid sein. Die Benetzungsschicht 6 besteht beispielsweise aus Gold oder Titan.

Beispielsweise wächst das Trägersubstrat-Material (z.B. Nikkel) beim stromlosen Abscheiden nur auf der Benetzungsschicht 6 an. Wird der Prozeß gestoppt bevor die Mesagräben zuwachsen, werden getrennte Trägersubstrat-Inseln 71 wie in Figur 13b abgebildet, erzielt. Diese Bauelemente können nun wie die in Figur 10d abgebildeten Bauelemente weiter verarbeitet werden. Zwar ist die Strukturtreue der Trägersubstrat-Inseln 71 nicht so gut wie beim Photolackverfahren (nämlich dem in den Figuren 10a bis 10g dargestellten Verfahren), dafür spart man aber die Kosten für eine Lackprozessierung und Belichtung.

Die in den Figuren 3a, 4 und 6a abgebildeten, erfindungsgemäßen Bauelemente können mit geeigneten Abwandlungen auch nach den erfindungsgemäßen Verfahren hergestellt werden, nämlich nach Abwandlungen der in Figuren 7, 9, 10, 11 und 13 dargestellten Verfahren.

Für die Herstellung der in den Figuren 3a, 4 und 6a abgebildeten Bauelemente muss das Trägersubstrat 7 bzw. die Trägersubstrat-Insel 71 strukturiert werden. Diese Strukturierung kann beispielsweise mittels Photolithographie, eines LIGA-Verfahrens oder eines anderen bekannten Verfahrens erreicht werden. Mit Hilfe der Photolithographie als Beispiel sollte vor dem Aufbringen des Trägersubstrats 7 ein geeigneter Photolack auf die Benetzungsschicht 6 aufgebracht, entsprechend belichtet und geätzt werden, so dass die negative Form der vertikalen Strukturelemente bzw. des Strukturelements 25 des gewünschten Bauelements erzielt wird. Zur Erreichung von Strukturelementen 25 mit hohen Aspektverhältnissen wird vorzugsweise ein LIGA-Verfahren oder ein dafür geeigneter Photolack (z.B. der ma-P 100 oder der SU-8 von Nano™) verwendet.

Um das in Figur 4 oder 6a abgebildete Bauelement herzustellen, kann der Photolack, wenn er ausreichend elastisch ist, z.B. nach dem LIGA-Verfahren im Bauelement belassen werden, oder es können die Zwischenräume 26 mit einem zusätzlichen Füllmaterial 27 gefüllt werden. Die letzte Alternative sollte nach der Auflösung des Photolacks durchgeführt werden. Dies kann durch ein Spritzverfahren, bei dem beispielsweise ein Thermoplast in die Zwischenräume hineingespritzt wird, durch Hineinfließen eines Füllmaterials 27 in der flüssigen Phase, z.B. bei hohen Temperaturen, durch Hineinfließen eines Klebers in der flüssigen Phase, das später trocknet oder aushärtet (wie Epoxidharz) oder durch ein anderes bekanntes Verfahren erfolgen.

In Rahmen des in den Figuren 7a bis 7g dargestellten Verfahrens kommt die Abzweigung zur Herstellung eines in Figur 3a, 4 oder 6a dargestellten Bauelements, nachdem das in Figur 7c abgebildete Stadium der Herstellung erreicht wird. Wie oben bereits beschrieben, wird der Photolack hier auf die Benetzungsschicht 6 aufgebracht und mit mehreren negativen Formen von Strukturelementen 25 strukturiert, wenn das in Figur 3a oder 4 abgebildete Bauelement angestrebt wird. Hilfsweise wird der Photolack mit einer negativen Form des Strukturelement 25 strukturiert, wenn das in Figur 6a abgebildete Bauelement zu erreichen ist. Danach wird das Trägersubstrat 7 nach einem der oben genannten Verfahren abgeschieden, allerdings über den Photolack hinaus bis zur gewünschten Dicke des Trägerbodens 24

(z.B. 50 μm). Das Trägersubstrat ist somit beispielsweise einstückig gebildet. Der Photolack kann zu jeder Zeit vor dem Vereinzeln der Bauelemente aufgelöst werden, oder auch nicht. Wenn der Photolack elastischer oder weicher als das Material des Trägersubstrats 7 ist, dann kann der Photolack zugleich als Füllmaterial 27 für das in den Figuren 4 oder 6a abgebildete Bauelement dienen. Ansonsten kann das Bauelement wie zu den Figuren 7e bis 7g bereits beschrieben, weiterverarbeitet werden.

Das Trägersubstrat 7 kann auch strukturiert werden, nachdem das in Figur 9b gezeigte Prozeßstadium erreicht wird. Wie oben bereits beschrieben, wird der Photolack auf die Benetzungsschicht 6 aufgebracht und strukturiert und das Trägersubstrat 7 so aufgebracht, dass zumindest ein Strukturelement und ein Zwischenraum geformt und ein Trägerboden 24 ausgebildet wird. Nach der optionalen Auflösung des Photolacks und der optionalen Anwendung eines Füllmaterials 27 kann die Weiterverarbeitung nach den Figuren 9d bis 9f erfolgen.

Ähnlicherweise kann die Strukturierung nach dem in Figur 10b erreichten Herstellungsstadium stattfinden. Hier wird der Photolack auf die zwischen den Trennstegen 13 liegende Benetzungsschicht 6 aufgebracht und strukturiert. Wie oben bereits beschrieben, wird das Trägersubstrat 7 auf die zwischen den Trennstegen liegende Benetzungsschicht 6 bzw. auf den Photolack aufgebracht, so dass auch ein Trägerboden 24 ausgebildet wird. Die Weiterverarbeitung gemäß Figuren 10d bis 10g kann mit oder ohne Auflösung des Photolacks bzw. der Anwendung eines Füllmaterials 27 erfolgen.

Nach dem in den Figuren 11a bis 11d abgebildeten Verfahren kann das Trägersubstrat wie bereits oben beschrieben, strukturiert werden. Die Strukturelemente 25 sind niedriger als die Trennstege 13, damit dem Bauelement während eines eventuellen Scherverfahrens genügend mechanische Stabilität verliehen werden kann. Beispielsweise sind die Strukturelemente 25 ca. 15 μm hoch und die Trennstege 13 ca. 50 μm hoch. Die Trennstege 13 können i.d.R. zwischen 50 μm und 200 μm hoch sein, aber je höher die Trennstege 13 sind, desto dicker wird das Trägersubstrat 7 und desto mehr Material wird benötigt, was wiederum eine Kostenfrage ist.

Gemäß dem in Figuren 13a und 13b dargestellten Verfahren kann das Erzeugen eines strukturierten Trägersubstrats 7 zur Herstellung eines in den Figuren 3a, 4 oder 6a dargestellten Bauelements über der in Figur 13a abgebildeten Benetzungsschicht 6 erfolgen.

Diese Patentanmeldung beansprucht die Priorität der deutschen Patentanmeldung 102 45 631.3-33, deren Offenbarungsgehalt hiermit durch Rückbezug aufgenommen wird.

Der Schutzumfang der Erfindung ist nicht durch die Beschreibung der Erfindung anhand der Ausführungsbeispiele beschränkt. Vielmehr umfasst die Erfindung jedes neue Merkmal sowie jede Kombination von Merkmalen, was insbesondere jede Kombination von Merkmalen in den Patentansprüchen beinhaltet, auch wenn diese Kombination nicht explizit in den Patentansprüchen angegeben ist.

**Patentansprüche**

1. Halbleiterbauelement mit einer lichtemittierenden Halbleiterschicht oder einem lichtemittierenden Halbleiterelement (2) und zwei Kontaktstellen (3,8), die als eine Kontaktschicht (3) und ein Kontakt (8) ausgebildet sind, wobei, dass das Bauelement auf einem Trägersubstrat (7) angeordnet ist und das Trägersubstrat (7) vertikal strukturiert ist,

   - das Trägersubstrat (7) einen Trägerboden (24) aufweist, der zumindest durch einen Zwischenraum (26) und ein vertikales Strukturelement (25) räumlich von der Halbleiterschicht (2) getrennt ist, dadurch charakterisiert, dass
   - die Zwischenräume (26) mit einem Füllmaterial (27) befüllt sind, das elastischer ist als das Material des Trägersubstrats (7).

2. Halbleiterbauelement nach Anspruch 1, bei dem das Trägersubstrat (7) einstückig gebildet ist.

3. Halbleiterbauelement nach Anspruch 1 oder 2, bei dem zumindest ein Strukturelement (25) sich mittig unter dem Zentrum der Halbleiterschicht (2) befindet.

4. Halbleiterbauelement nach einem der Ansprüche 1 bis 3, bei dem das Strukturelement (25) in Querschnitt kreisförmig oder rechteckig ist.

5. Halbleiterbauelement nach einem der Ansprüche 1 bis 4, bei dem das Strukturelement oder die Strukturelemente ein Aspektverhältnis von zumindest zwei aufweist/aufweisen.

6. Halbleiterbauelement nach einem der Ansprüche 1 bis 5, bei dem das Verhältnis Halbleiterschichtlänge/-Strukturelementhöhe 15 nicht übersteigt.

7. Halbleiterbauelement nach einem der Ansprüche 1 bis 6, bei dem zwischen dem Trägersubstrat (7) und der näher an dem Trägersubstrat (7) liegenden Kontaktstelle (3) zumindest eine Benetzungsschicht (6) ausgebildet ist.

8. Halbleiterbauelement nach einem der Ansprüche 1 bis 7, bei dem zwischen der Kontaktstelle (3) und dem Trägersubstrat (7) oder zwischen der Kontaktstelle (3) und der Benetzungsschicht (6) zumindest eine Reflexionsschicht (4) angeordnet ist.

9. Halbleiterbauelement nach einem der Ansprüche 1 bis 8,
bei dem zwischen der Reflexionsschicht (4) und dem Trägersubstrat (7) oder zwischen der Reflexionsschicht (4) und der Benetzungsschicht (6) zumindest eine Diffusionsbarriere (5) angeordnet ist.

10. Halbleiterbauelement nach einem der Ansprüche 1 bis 9,
bei dem das Trägersubstrat (7) elektrisch leitfähig ist.

11. Verfahren zur Herstellung eines lichtemittierenden Halbleiterbauelements, das die folgenden Verfahrensschritte aufweist:

(a) Epitaktisches Abscheiden einer lichtemittierenden Halbleiterschicht (2) auf einem Wachstumssubstrat (1),
(b) Versehen der Halbleiterschicht (2) mit einer metallischen Kontaktschicht (3),
(ba) Ätzen von Mesagräben (10) zur Definition von einzelnen Chips zwischen den Mesagräben (10), wobei die Mesagräben (10) zumindest durch die gesamte Halbleiterschicht (2) und die gesamte Kontaktschicht (3) hindurchreichen,
(c) Erzeugen einer Haft- und Benetzungsschicht (6) zumindest über der metallischen Kontaktschicht (3),
(d) Aufbringen, Erzeugen oder Abscheiden eines mechanisch stabilen Trägersubstrats (7) auf die Haft- und Benetzungsschicht (6),
(e) Trennen der Halbleiterschicht (2) von dem Wachstumssubstrat (1),
(f) Aufbringen eines elektrischen Kontaktes (8) auf der Halbleiterschicht (2) und
(g) Vereinzeln der Chips durch Trennung entlang den Mesagräben (10), wobei

- die Erzeugung oder das Abscheiden des Trägersubstrats (7) auf die Haft- und Benetzungsschicht (6) gemäß Verfahrensschritt (d) auf die folgende Weise durchgeführt wird:
- ein Photolack wird auf die Benetzungsschicht (6) aufgebracht und entsprechend durchgehend strukturiert, so dass eine oder mehrere negative Formen von vertikalen Strukturelementen (25) entstehen,
- das Trägersubstrat wird in die negativen Formen und auf den Photolack bis zur Bildung eines Trägerbodens (24) oberhalb des Photolacks aufgebracht, wobei
- der Photolack selektiv entfernt wird,

- die durch Entfernung des Photolacks entstanden Zwischenräume (26) mit einem Füllmaterial (27) aufgefüllt werden, und
- ein Füllmaterial (27) verwendet wird, das elastischer als das Material des Trägersubstrats (7) ist.

12. Verfahren nach Anspruch 11,
bei dem nach dem Verfahrensschritt (b) eine Reflexionsschicht (4) auf der Kontaktschicht (3) aufgebracht oder in der Kontaktschicht (3) integriert wird.

13. Verfahren nach Anspruch 12,
bei dem eine Diffusionsbarriere (5) auf der Reflexionsschicht (4) aufgebracht wird.

14. Verfahren nach einem der Ansprüche 11 bis 13,
bei dem die Kontaktschicht gemäß Verfahrensschritt (b), die Reflexionsschicht (4), die Diffusionsbarriere (5), die Benetzungsschicht (6) gemäß Verfahrensschritt (c) und/oder der Kontakt (8) gemäß Verfahrensschritt (g) bzw. (f) mittels Sputterns oder Aufdampfens aufgebracht werden.

15. Verfahren nach einem der Ansprüche 11 bis 14,
bei dem

- ein selektiv auflösbares Material für das Wachstumssubstrat (1) verwendet wird und
- das Trennen der Halbleiterschicht (2) von dem Wachstumssubstrat (1) gemäß Verfahrensschritt (e) durch selektives Ätzen des Wachstumssubstrats (1) erfolgt.

16. Verfahren nach einem der Ansprüche 11 bis 15 bei dem

- vor dem Verfahrensschritt (a) eine Opferschicht, die aus einem selektiv auflösbaren Material besteht, auf das Wachstumssubstrat aufgebracht wird, so dass der Verfahrensschritt (a) auf dieser Opferschicht stattfindet und
- das Trennen der Halbleiterschicht (2) von dem Wachstumssubstrat (1) gemäß Verfahrensschritt (e) durch selektives Ätzen der Opferschicht erfolgt.

17. Verfahren nach einem der Ansprüche 11 bis 15,
bei dem ein bereits laminiertes Substrat als Wachstumssubstrat (1) eingesetzt wird, wobei das laminierte Substrat eine Haftschicht mit geeigneten Sollbruchstellen aufweist, an denen während des Verfahrensschritts (e) das Wachstumssubstrat (1) gezielt von der Halbleiterschicht (2) getrennt wird.

18. Verfahren nach einem der Ansprüche 11 bis 15,
bei dem das Trennen der Halbleiterschicht (2) von dem Wachstumssubstrat (1) gemäß Verfahrensschritt (e) durch ein Laserliftoff-Verfahren erfolgt, indem die Halbleiterschicht (2) an der Grenzfläche mit dem Wachstumssubstrat (1) mittels eines Lasers zersetzt wird.

19. Verfahren nach einem der Ansprüche 11 bis 18, bei dem das mechanisch stabile Trägersubstrat (7) durch ein Sputterverfahren, ein CVD-Verfahren, ein galvanisches Verfahren oder stromloses Plattieren abgeschieden wird.

20. Verfahren nach einem der Ansprüche 11 bis 19, bei dem nach dem Verfahrensschritt (d) auf das Trägersubstrat (7) ein zusätzliches Hilfssubstrat (12) aufgebracht wird.

21. Verfahren nach dem Anspruch 20, bei dem das zusätzliche Hilfssubstrat (12) auf das Trägersubstrat (7) mittels eines Klebeverfahrens oder Lötens befestigt wird.

22. Verfahren nach Anspruch 20 oder 21, bei dem eine zum Löten benötigte Lotschicht (11) und/oder das Hilfssubstrat (12) mittels Sputterns, Aufdampfens oder galvanisch aufgebracht werden/wird.

23. Verfahren nach einem der Ansprüche 11 bis 22, bei dem das Trägersubstrat (7) aus einer Schichtenfolge besteht, deren Schichten in der Dicke so aufeinander abgestimmt werden, dass die Schicht mit dem größten Elastizitätsmodul (21) am dünnsten ist und die Schicht mit dem kleinsten Elastizitätsmodul (20) am dicksten ist.

24. Verfahren nach einem der Ansprüche 11 bis 22, bei dem die gesamte Dicke des Trägersubstrats (7) und gegebenenfalls des Hilfssubstrats (12) und der Lot- oder Klebeschicht (11) nicht 15 Mikrometer überschreitet.

25. Verfahren nach einem der Ansprüche 11 bis 23, bei dem nach dem Aufbringen des Kontaktes (8) auf der Halbleiterschicht (2) gemäß Verfahrensschritt (g) bzw. (f) eine Passivierungsschicht (9) zumindest teilweise über die Halbleiterschicht (2) aufgebracht wird.

26. Verfahren nach einem der Ansprüche 11 bis 24, bei dem nach dem Aufbringen des Kontaktes (8) auf der Halbleiterschicht (2) gemäß Verfahrensschritt (g) bzw. (f) dreidimensionale Strukturen zur Optimierung der Lichtauskopplung auf die Halbleiterschicht (2) und/oder, wenn vorhanden, auf die Passivierungsschicht (9) aufgebracht werden.

27. Verfahren nach Anspruch 26, bei dem die dreidimensionalen Strukturen zur Optimierung der Lichtauskopplung pyramidenförmig mit zumindest drei sichtbaren Flächen je Pyramide auf der Halbleiterschicht (2) und/oder der Passivierungsschicht (9) oder kegelförmig auf der Halbleiterschicht (2) und/oder der Passivierungsschicht (9) ausgebildet werden.

28. Verfahren nach Anspruch 26 oder 27, bei dem die dreidimensionalen Strukturen zur Optimierung der Lichtauskopplung mittels nasschemischen oder Trocken-Ätzens erzeugt werden.

29. Verfahren nach einem der Ansprüche 11 bis 28, bei dem nach Verfahrensschritt (b) eine Passivierungsschicht (9) zumindest teilweise über die Halbleiterschicht (2), die Kontaktschicht (3) und, wenn vorhanden, auch über die Reflexionsschicht (4) und die Diffusionsbarriere (5) aufgebracht wird.

30. Verfahren nach einem der Ansprüche 11 bis 29, bei dem das Vereinzeln der Chips im Verfahrensschritt (h) bzw. (g) durch Sägen oder Laserschneiden erfolgt.

31. Verfahren nach einem der Ansprüche 11 bis 30, bei dem nach dem Verfahrensschritt (c) in den Mesagräben (10) auf der Benetzungsschicht (6) Trennstege (13) so aufgebracht werden, dass die Trennstege (13) die Mesagräben (10) über die gesamte Länge vollkommen füllen und die dazwischen liegende Oberfläche der Benetzungsschicht (6) überragen.

32. Verfahren nach Anspruch 31, bei dem die Trennstege (13) mit einer Höhe von zumindest 10 Mikrometer über dem Grabenboden aufgebracht werden.

33. Verfahren nach einem der Ansprüche 31 bis 32, bei dem ein Photolack als Material für die Trennstege (13) verwendet wird.

34. Verfahren nach einem der Ansprüche 31 bis 33, bei dem die Trennstege mittels Photolithographie oder des LIGA-Verfahrens aufgebracht werden.

35. Verfahren nach einem der Ansprüche 31 bis 34, bei dem die Trennstege (13) so ausgebildet werden, dass sie in Querschnitt eine Spitze aufweisen.

36. Verfahren nach einem der Ansprüche 31 bis 35, bei dem der Verfahrensschritt (d) lediglich in den Räumen zwischen den Trennstegen (13) stattfindet und das Trägersubstrat-Material bis zur Höhe der Trennstege (13) aufgebracht wird.

37. Verfahren nach einem der Ansprüche 31 bis 36, bei dem der Verfahrensschritt (d) lediglich in den Räumen zwischen den Trennstegen (13) stattfindet und das Trägersubstrat-Material über die Höhe der Trennstege (13) hinaus aufgebracht wird.

**38.** Verfahren nach Anspruch 37,
bei dem nach dem Aufbringen des Kontaktes (8) auf der Halbleiterschicht (2) gemäß Verfahrensschritt (g) bzw. (f) das Material der Trennstege (13) selektiv entfernt wird.

**39.** Verfahren nach Anspruch 38,
bei dem das Material der Trennstege (13) mittels eines Lösungsmittels aufgelöst wird.

**40.** Verfahren nach einem der Ansprüche 37 bis 39,
bei dem das Vereinzeln der Chips im Verfahrensschritt (h) bzw. (g) mittels eines Scherprozesses durchgeführt wird.

**41.** Verfahren nach einem der Ansprüche 37 bis 40,
bei dem während des Verfahrensschritts (h) die Chips in Streifen (17) vereinzelt werden und dann direkt von diesen Streifen (17) weg mittels eines Trenn- und Bondwerkzeugs (18) montiert werden.

**42.** Verfahren nach Anspruch 36,
bei dem

- vor dem Verfahrensschritt (e) das Material der Trennstege (13) selektiv entfernt wird, wobei Trägersubstrat-Inseln (71) entstehen,
- danach die gesamte Struktur oberhalb des Wachstumssubstrats (1) samt den herausragenden freien Trägersubstrat-Inseln (71) und Mesagräben (10) von einem Hilfsmaterial (14) komplett überformt werden und
- die Vereinzelung der Chips im Verfahrensschritt (h) bzw. (g) durchgeführt wird, indem eine Trägerfolie (15) über den elektrischen Kontakten (8) auf der Halbleiterschicht (2) aufgebracht wird und das Hilfsmaterial (14) selektiv entfernt wird.

**43.** Verfahren nach Anspruch 42,
bei dem ein Metall, Polymer und/oder Glas basiertes Material als das Hilfsmaterial (14) verwendet wird.

**44.** Verfahren nach einem der Ansprüche 11 bis 30,
bei dem

- das Aufbringen der Haft- und Benetzungsschicht (6) gemäß Verfahrensschritt (c) sich lediglich auf die Oberfläche der äußersten Schicht beschränkt,
- vor dem Verfahrensschritt (d) die Mesagräben (10) komplett mit einer Anti-Benetzungsschicht (16) überdeckt werden,
- das Aufbringen des Trägersubstrats (7) gemäß dem Verfahrensschritt (d) dementsprechend nur auf die Haft- und Benetzungsschicht (6) stattfindet und vor dem Zusammenwachsen von benachbarten Trägersubstrat-Inseln (71) gestoppt wird,
- die gesamte Struktur oberhalb des Wachstumssubstrats (1) samt den herausragenden freien Trägersubstrat-Inseln (71) und Mesagräben (10) von einem Hilfsmaterial (14) komplett überformt werden und
- die Vereinzelung der Chips im Verfahrensschritt (h) bzw. (g) durchgeführt wird, indem eine Trägerfolie (15) über den elektrischen Kontakten (8) auf der Halbleiterschicht (2) aufgebracht wird und das Hilfsmaterial (14) selektiv entfernt wird.

**45.** Verfahren nach Anspruch 11, bei dem der Photolack so strukturiert wird, dass zumindest eine negative Form eines vertikalen Strukturelements unter dem Zentrum der Halbleiterschicht (2) vorgesehen ist.

**Claims**

**1.** Semiconductor component having a light-emitting semiconductor layer or a light-emitting semiconductor element (2) and two contact locations (3, 8), which are formed as a contact layer (3) and a contact (8), wherein
the component is arranged on a carrier substrate (7) and the carrier substrate (7) is patterned vertically, the carrier substrate (7) has a carrier base (24) that is spatially separated from the semiconductor layer (2) at least by an interspace (26) and a vertical structure element (25), **characterized in that**
the interspaces (26) are filled with a filling material (27) that is more elastic than the material of the carrier substrate (7).

**2.** Semiconductor component according to Claim 1, in which the carrier substrate (7) is formed in one piece.

**3.** Semiconductor component according to Claim 1 or 2, in which at least one structure element (25) is situated centrally above the center of the semiconductor layer (2).

**4.** Semiconductor component according to one of Claims 1 to 3,
in which the structure element (25) is circular or rectangular in cross section.

**5.** Semiconductor component according to one of Claims 1 to 4,
in which the structure element or the structure elements has/have an aspect ratio of at least two.

6. Semiconductor component according to one of Claims 1 to 5,
   in which the ratio of semiconductor layer length/structure element height does not exceed 15.

7. Semiconductor component according to one of Claims 1 to 6,
   in which at least one wetting layer (6) is formed between the carrier substrate (7) and the contact location (3) situated nearer to the carrier substrate (7).

8. Semiconductor component according to one of Claims 1 to 7,
   in which at least one reflection layer (4) is arranged between the contact location (3) and the carrier substrate (7) or between the contact location (3) and the wetting layer (6).

9. Semiconductor component according to one of Claims 1 to 8,
   in which at least one diffusion barrier (5) is arranged between the reflection layer (4) and the carrier substrate (7) or between the reflection layer (4) and the wetting layer (6).

10. Semiconductor component according to one of Claims 1 to 9,
    in which the carrier substrate (7) is electrically conductive.

11. Method for producing a light-emitting semiconductor component, which has the following method steps:

    (a) epitaxial deposition of a light-emitting semiconductor layer (2) on a growth substrate (1),
    (b) provision of the semiconductor layer (2) with a metallic contact layer (3),
    (ba) etching of mesa trenches (10) for the definition of individual chips between the mesa trenches (10), the mesa trenches (10) at least extending through the entire semiconductor layer (2) and the entire contact layer (3),
    (c) production of an adhesion and wetting layer (6) at least above the metallic contact layer (3),
    (d) application, production or deposition of a mechanically stable carrier substrate (7) onto the adhesion and wetting layer (6),
    (e) separation of the semiconductor layer (2) from the growth substrate (1),
    (f) application of an electrical contact (8) on the semiconductor layer (2), and
    (g) singulation of the chips by separation along the mesa trenches (10), wherein
    the production or the deposition of the carrier substrate (7) onto the adhesion and wetting layer (6) in accordance with method step (d) is carried out in the following manner:

    - a photoresist is applied to the wetting layer (6) and patterned correspondingly throughout such that one or a plurality of negative forms of vertical structure elements (25) arise,
    - the carrier substrate is applied into the negative forms and onto the photoresist until the formation of a carrier base (24) above the photoresist, wherein
    the photoresist is selectively removed
    - the interspaces (26) resulting from removal of the photoresist are filled with a filling material (27), and
    a filling material (27) is used which is more elastic than the material of the carrier substrate (7).

12. Method according to Claim 11,
    in which, after method step (b) a reflection layer (4) is applied on the contact layer (3) or integrated in the contact layer (3).

13. Method according to Claim 12,
    in which a diffusion barrier (5) is applied on the reflection layer (4).

14. Method according to one of Claims 11 to 13,
    in which the contact layer in accordance with method step (b), the reflection layer (4), the barrier layer (5), the wetting layer (6) in accordance with method step (c) and/or the contact (8) in accordance with method step (g) or (f) are applied by means of sputtering or vapor deposition.

15. Method according to one of Claims 11 to 14,
    in which

    - a selectively dissoluble material is used for the growth substrate (1), and
    - the separation of the semiconductor layer (2) from the growth substrate (1) in accordance with method step (e) is effected by selective etching of the growth substrate (1).

16. Method according to one of Claims 11 to 15,
    in which

    - prior to method step (a), a sacrificial layer comprising a selectively dissoluble material is applied to the growth substrate, so that method step (a) takes place on said sacrificial layer, and
    - the separation of the semiconductor layer (2) from the growth substrate (1) in accordance with method step (e) is effected by selective etching of the sacrificial layer.

17. Method according to one of Claims 11 to 15,
    in which an already laminated substrate is used as the growth substrate (1), the laminated substrate having an adhesion layer with suitable desired breaking locations at which the growth substrate (1) is separated from the semiconductor layer (2) in a targeted manner during method step (e).

18. Method according to one of Claims 11 to 15, in which the separation of the semiconductor layer (2) from the growth substrate (1) in accordance with method step (e) is effected by means of a laser lift-off method by using a laser to decompose the semiconductor layer (2) at the interface with the growth substrate (1).

19. Method according to one of Claims 11 to 18, in which the mechanically stable carrier substrate (7) is deposited by means of a sputtering method, a CVD method, a galvanic method or electroless plating.

20. Method according to one of Claims 11 to 19, in which, after method step (d), an additional auxiliary substrate (12) is applied to the carrier substrate (7).

21. Method according to Claim 20, in which the additional auxiliary substrate (12) is fixed onto the carrier substrate (7) by means of an adhesive-bonding method or soldering.

22. Method according to Claim 20 or 21, in which a solder layer (11) required for soldering and/or the auxiliary substrate (12) are/is applied by means of sputtering, vapor deposition or galvanically.

23. Method according to one of Claims 11 to 22, in which the carrier substrate (7) comprises a layer sequence, the layers of which are coordinated with one another in terms of thickness such that the layer having the largest modulus of elasticity (21) is the thinnest and the layer having the smallest modulus of elasticity (20) is the thickest.

24. Method according to one of Claims 11 to 22, in which the total thickness of the carrier substrate (7) and, if appropriate, of the auxiliary substrate (12) and of the solder or adhesive-bonding layer (11) does not exceed 15 micrometers.

25. Method according to one of Claims 11 to 23, in which, after the contact (8) has been applied on the semiconductor layer (2) in accordance with method step (g) or (f), a passivation layer (9) is applied at least partly over the semiconductor layer (2).

26. Method according to one of Claims 11 to 24, in which, after the contact (8) has been applied on the semiconductor layer (2) in accordance with method step (g) or (f), three-dimensional structures for optimizing the coupling-out of light are applied to the semiconductor layer (2) and/or, if present, to the passivation layer (9).

27. Method according to Claim 26, in which the three-dimensional structures for optimizing the coupling-out of light are formed in pyramidal fashion with at least three visible areas per pyramid on the semiconductor layer (2) and/or the passivation layer (9) or in conical fashion on the semiconductor layer (2) and/or the passivation layer (9).

28. Method according to Claim 26 or 27, in which the three-dimensional structures for optimizing the coupling-out of light are produced by means of wet-chemical or dry etching.

29. Method according to one of Claims 11 to 28, in which, after method step b), a passivation layer (9) is applied at least partly over the semiconductor layer (2), the contact layer (3) and, if present, also over the reflection layer (4) and the diffusion barrier (5).

30. Method according to one of Claims 11 to 29, in which the singulation of the chips is effected in method step (h) or (g) by sawing or laser cutting.

31. Method according to one of Claims 11 to 30, in which, after method step (c), separating ridges (13) are applied in the mesa trenches (10) on the wetting layer (6) in such a way that the separating ridges (13) completely fill the mesa trenches (10) over the entire length and project above the intervening surface of the wetting layer (6).

32. Method according to Claim 31, in which the separating ridges (13) are applied with a height of at least 10 micrometers above the trench bottom.

33. Method according to one of Claims 31 to 32, in which a photoresist is used as material for the separating ridges (13).

34. Method according to one of Claims 31 to 33, in which the separating ridges are applied by means of photolithography or the LIGA method.

35. Method according to one of Claims 31 to 34, in which the separating ridges (13) are formed in such a way that they have a tip in cross section.

36. Method according to one of Claims 31 to 35, in which method step (d) takes place only in the spaces between the separating ridges (13) and the carrier substrate material is applied up to the height of the separating ridges (13).

**37.** Method according to one of Claims 31 to 36, in which method step (d) takes place only in the spaces between the separating ridges (13) and the carrier substrate material is applied beyond the height of the separating ridges (13).

**38.** Method according to Claim 37, in which, after the contact (8) has been applied on the semiconductor layer (2) in accordance with method step (g) or (f), the material of the separating ridges (13) is selectively removed.

**39.** Method according to Claim 38, in which the material of the separating ridges (13) is dissolved by means of a solvent.

**40.** Method according to one of Claims 37 to 39, in which the singulation of the chips in method step (h) or (g) is carried out by means of a shear process.

**41.** Method according to one of Claims 37 to 40, in which, during method step (h), the chips are singulated in strips (17) and are then mounted directly away from said strips (17) by means of a separating and bonding tool (18).

**42.** Method according to Claim 36, in which

- prior to method step (e), the material of the separating ridges (13) is selectively removed, carrier substrate islands (71) arising,
- the entire structure above the growth substrate (1) together with the projecting free carrier substrate islands (71) and mesa trenches (10) are then completely overformed by an auxiliary material (14), and
- the singulation of the chips is carried out in method step (h) or (g) by applying a carrier film (15) over the electrical contacts (8) on the semiconductor layer (2) and selectively removing the auxiliary material (14).

**43.** Method according to Claim 42, in which a metal, polymer and/or glass-based material is used as the auxiliary material (14).

**44.** Method according to one of Claims 11 to 30, in which

- the application of the adhesion and wetting layer (6) in accordance with method step (c) is restricted only to the surface of the outermost layer,
- prior to method step (d), the mesa trenches (10) are completely covered with an anti-wetting layer (16),
- the application of the carrier substrate (7) in accordance with method step (d) accordingly takes place only onto the adhesion and wetting layer (6) and is stopped before adjacent carrier substrate islands (71) grow together,
- the entire structure above the growth substrate (1) together with the projecting free carrier substrate islands (71) and mesa trenches (10) are completely overformed by an auxiliary material (14), and
- the singulation of the chips is carried out in method step (h) or (g) by applying a carrier film (15) over the electrical contacts (8) on the semiconductor layer (2) and selectively removing the auxiliary material (14).

**45.** Method according to Claim 11, in which the photoresist is patterned in such a way that at least one negative form of a vertical structure element is provided below the center of the semiconductor layer (2).

**Revendications**

**1.** Composant à semi-conducteur, comportant une couche de semi-conducteur photoémettrice ou un élément semi-conducteur photoémetteur (2) et deux points de contact (3, 8) qui sont conçus sous forme d'une couche de contact (3) et d'un contact (8), le composant étant disposé sur un substrat porteur (7) et le substrat porteur (7) étant structuré verticalement,

- le substrat porteur (7) comportant un socle (24) qui est séparé spatialement de la couche de semi-conducteur (2) au moins par un espace intermédiaire (26) et un élément structural vertical (25), **caractérisé en ce que**
- les espaces intermédiaires (26) sont remplis d'un matériau de remplissage (27) qui est plus élastique que le matériau du substrat porteur (7).

**2.** Composant à semi-conducteur selon la revendication 1, dans lequel le substrat porteur (7) a une structure monobloc.

**3.** Composant à semi-conducteur selon la revendication 1 ou 2, dans lequel au moins un élément structural (25) se trouve au milieu au-dessous du centre de la couche de semi-conducteur (2).

**4.** Composant à semi-conducteur selon l'une quelconque des revendications 1 à 3, dans lequel l'élément structural (25) a une section transversale circulaire ou rectangulaire.

**5.** Composant à semi-conducteur selon l'une quelconque des revendications 1 à 4, dans lequel l'élément structural ou les éléments structuraux présente(nt) un rapport de dimensions d'au moins deux.

**6.** Composant à semi-conducteur selon l'une quelconque des revendications 1 à 5, dans lequel le rapport longueur de la couche de semi-conducteur/ hauteur de l'élément structural n'excède pas 15.

**7.** Composant à semi-conducteur selon l'une quelconque des revendications 1 à 6, dans lequel au moins une couche d'imprégnation (6) est formée entre le substrat porteur (7) et le point de contact (3) se trouvant le plus près du substrat porteur (7).

**8.** Composant à semi-conducteur selon l'une quelconque des revendications 1 à 7, dans lequel au moins une couche de réflexion (4) est disposée entre le point de contact (3) et le substrat porteur (7) ou entre le point de contact (3) et la couche d'imprégnation (6).

**9.** Composant à semi-conducteur selon l'une quelconque des revendications 1 à 8, dans lequel au moins une barrière de diffusion (5) est disposée entre la couche de réflexion (4) et le substrat porteur (7) ou entre la couche de réflexion (4) et la couche d'imprégnation (6).

**10.** Composant à semi-conducteur selon l'une quelconque des revendications 1 à 9, dans lequel le substrat porteur (7) est conducteur de l'électricité.

**11.** Procédé pour la production d'un composant à semi-conducteur photoémetteur, qui comporte les étapes de processus suivantes :

(a) dépôt épitactique d'une couche de semi-conducteur photoémettrice (2) sur un substrat de croissance (1),
(b) étape consistant à munir la couche de semi-conducteur (2) d'une couche métallique de contact (3),
(ba) formation par attaque chimique de creux de mésas (10) pour la définition de puces individuelles entre les creux des mésas (10), les creux des mésas (10) traversant toute la couche de semi-conducteur (2) et toute la couche de contact (3),
(c) production d'une couche d'adhérence et d'imprégnation (6) au moins au-dessus de la couche de contact métallique de contact (3),
(d) application, production ou dépôt d'un substrat porteur (7) mécaniquement stable sur la couche d'adhérence et d'imprégnation (6),
(e) séparation de la couche de semi-conducteur (2) d'avec le substrat de croissance (1),
(f) application d'un contact électrique (8) sur la couche de semi-conducteur (2) et
(g) isolement des puces par séparation le long des creux des mésas (10),

- en effectuant la production ou le dépôt du substrat porteur (7) sur la couche d'adhérence et d'imprégnation (6) selon l'étape (d) du processus de la façon suivante :
- un vernis photosensible est appliqué sur la couche d'imprégnation (6) et structuré en totalité de façon correspondante, de sorte qu'il en résulte un ou plusieurs moules négatifs des éléments structuraux verticaux (25),
- on applique le substrat porteur dans les moules négatifs et sur le vernis photosensible, jusqu'à la formation d'un socle (24) au-dessus du vernis photosensible,
- en éliminant sélectivement le vernis photosensible,
- en remplissant avec un matériau de remplissage (27) les espaces intermédiaires (26) résultant de l'élimination du vernis photosensible, et
- en utilisant un matériau de remplissage (27) qui est plus élastique que le matériau du substrat porteur (7).

**12.** Procédé selon la revendication 11, dans lequel après l'étape (b) du processus une couche de réflexion (4) est appliquée sur la couche de contact (3) ou intégrée dans la couche de contact (3).

**13.** Procédé selon la revendication 12, dans lequel on applique une barrière de diffusion (5) sur la couche de réflexion (4).

**14.** Procédé selon l'une quelconque des revendications 11 à 13, dans lequel on applique par pulvérisation cathodique ou dépôt en phase vapeur la couche de contact selon l'étape (b) du processus, la couche de réflexion (4), la barrière de diffusion (5), la couche d'imprégnation (6) selon l'étape (c) du processus et/ou le contact (8) selon l'étape (g) ou (f) du processus.

**15.** Procédé selon l'une quelconque des revendications 11 à 14, dans lequel

- on utilise pour le substrat de croissance (1) un matériau sélectivement détachable, et
- la séparation de la couche de semi-conducteur (2) d'avec le substrat de croissance (1) selon l'étape (e) du processus s'effectue par attaque chimique sélective du substrat de croissance (1).

**16.** Procédé selon l'une quelconque des revendications 11 à 15, dans lequel

- avant l'étape (a) du processus on applique sur le substrat de croissance une couche sacrificielle, qui consiste en un matériau sélectivement détachable, de sorte que l'étape (a) du processus a lieu sur cette couche sacrificielle et
- la séparation de la couche de semi-conducteur (2) d'avec le substrat de croissance (1) selon l'étape (e) du processus s'effectue par attaque chimique sélective de la couche sacrificielle.

**17.** Procédé selon l'une quelconque des revendications 11 à 15, dans lequel on utilise comme substrat de croissance (1) un substrat déjà stratifié, le substrat stratifié comportant une couche d'adhérence à points de rupture convenables, au niveau desquels le substrat de croissance (1) est intentionnellement séparé de la couche de semi-conducteur (2) pendant l'étape (e) du processus.

**18.** Procédé selon l'une quelconque des revendications 11 à 15, dans lequel la séparation de la couche de semi-conducteur (2) d'avec le substrat de croissance (1) selon l'étape (e) du processus s'effectue par un procédé de décollement au laser, par destruction au moyen d'un laser de la couche de semi-conducteur (2) à l'interface avec le substrat de croissance (1).

**19.** Procédé selon l'une quelconque des revendications 11 à 18, dans lequel le substrat porteur (7) mécaniquement stable est déposé par un procédé de pulvérisation cathodique, un procédé CVD, un procédé galvanoplastique ou plaquage sans courant.

**20.** Procédé selon l'une quelconque des revendications 11 à 19, dans lequel après l'étape (d) du processus on applique sur le substrat porteur (7) un substrat auxiliaire supplémentaire (12).

**21.** Procédé selon la revendication 20, dans lequel le substrat auxiliaire supplémentaire (12) est fixé sur le substrat porteur (7) au moyen d'un procédé de collage ou de brasage.

**22.** Procédé selon la revendication 20 ou 21, dans lequel on applique une couche de brasage (11) requise pour le brasage et/ou on applique le substrat auxiliaire (12) par pulvérisation cathodique, dépôt par vaporisation ou par galvanoplastie.

**23.** Procédé selon l'une quelconque des revendications 11 à 22, dans lequel le substrat porteur (7) consiste en une succession de couches dont les couches sont adaptées les unes aux autres quant à leur épaisseur, de sorte que la couche ayant le plus grand module d'élasticité (21) est la plus mince et la couche ayant le plus faible module d'élasticité (20) est la plus épaisse.

**24.** Procédé selon l'une quelconque des revendications 11 à 22, dans lequel l'épaisseur totale du substrat porteur (7) et éventuellement du substrat auxiliaire (12) et de la couche de colle ou de brasage (11) n'excède pas 15 micromètres.

**25.** Procédé selon l'une quelconque des revendications 11 à 23, dans lequel après l'application du contact (8) sur la couche de semi-conducteur (2) selon l'étape (g) ou (f) du processus, on applique une couche de passivation (9) au moins en partie au-dessus de la couche de semi-conducteur (2).

**26.** Procédé selon l'une quelconque des revendications 11 à 24, dans lequel après l'application du contact (8) sur la couche de semi-conducteur (2) selon l'étape (g) ou (f) du processus, on applique sur la couche de semi-conducteur (2) et/ou, si elle est présente, sur la couche de passivation (9) des structures tridimensionnelles pour l'optimisation de l'émission de la lumière.

**27.** Procédé selon la revendication 26, dans lequel les structures tridimensionnelles pour l'optimisation de l'émission de lumière sont conçues en forme pyramidale avec au moins trois faces visibles par pyramide sur la couche de semi-conducteur (2) et/ou la couche de passivation (9) ou en forme conique sur la couche de semi-conducteur (2) et/ou la couche de passivation (9).

**28.** Procédé selon la revendication 26 ou 27, dans lequel les structures tridimensionnelles pour l'optimisation de l'émission de lumière sont engendrées par attaque chimique par voie humide ou par voie sèche.

**29.** Procédé selon l'une quelconque des revendications 11 à 28, dans lequel après l'étape (b) du processus on applique une couche de passivation (9) au moins en partie au-dessus la couche de semi-conducteur (2), la couche de contact (3) et, si présentes, également au-dessus de la couche de réflexion (4) et la barrière de diffusion (5).

30. Procédé selon l'une quelconque des revendications 11 à 29,
dans lequel l'isolement des puces dans l'étape (h) ou (g) du processus s'effectue par sciage ou découpage au laser.

31. Procédé selon l'une quelconque des revendications 11 à 30,
dans lequel après l'étape (c) du processus on applique dans les creux de mésas (10) sur la couche d'imprégnation (6) des nervures de séparation (13) de sorte que les nervures de séparation (13) remplissent complètement les creux de mésas (10) sur toute la longueur et surplombent la surface de la couche d'imprégnation (6) qui se trouve entre eux.

32. Procédé selon la revendication 31,
dans lequel les nervures de séparation (13) sont appliquées avec une hauteur d'au moins 10 micromètres au-dessus du fond des creux.

33. Procédé selon l'une quelconque des revendications 31 à 32,
dans lequel on utilise comme matériau pour les nervures de séparation (13) un vernis photosensible.

34. Procédé selon l'une quelconque des revendications 31 à 33,
dans lequel les nervures de séparation sont appliquées par photolithographie ou le procédé LIGA.

35. Procédé selon l'une quelconque des revendications 31 à 34,
dans lequel les nervures de séparation (13) sont conçues de manière à présenter une pointe en section transversale.

36. Procédé selon l'une quelconque des revendications 31 à 35,
dans lequel l'étape (d) du processus a lieu seulement dans les espaces entre les nervures de séparation (13) et le matériau du substrat-porteur est appliqué jusqu'à la hauteur des nervures de séparation (13).

37. Procédé selon l'une quelconque des revendications 31 à 36,
dans lequel l'étape (d) du processus a lieu seulement dans les espaces entre les nervures de séparation (13) et le matériau du substrat porteur est appliqué jusqu'au-dessus de la hauteur des nervures de séparation (13).

38. Procédé selon la revendication 37,
dans lequel après l'application du contact (8) sur la couche de semi-conducteur (2) selon l'étape (g) ou (f) du processus on élimine sélectivement le matériau des nervures de séparation (13).

39. Procédé selon la revendication 38,
dans lequel on détache le matériau des nervures de séparation (13) au moyen d'un solvant.

40. Procédé selon l'une quelconque des revendications 37 à 39,
dans lequel l'isolement des puces dans l'étape (h) ou (g) du processus est effectué au moyen d'un processus de cisaillement.

41. Procédé selon l'une quelconque des revendications 37 à 40,
dans lequel pendant l'étape (h) du processus les puces sont isolées en bandes (17) et ensuite sont directement montées à partir de ces bandes (17) au moyen d'un outil de séparation et d'assemblage (18).

42. Procédé selon la revendication 36,
dans lequel

- avant l'étape (e) du processus on élimine sélectivement le matériau des nervures de séparation (13), de sorte qu'il en résulte des îlots de substrat porteur (71),
- ensuite on surmoule entièrement avec un matériau auxiliaire (14) l'ensemble de la structure au-dessus du substrat de croissance (1) y compris les îlots de substrat porteur (71) libres faisant saillie et les creux de mésas (10) et
- on effectue dans l'étape (h) ou (g) du processus l'isolement des puces en appliquant un film de support (15) au-dessus des contacts électriques (8) sur la couche de semi-conducteur (2) et en éliminant sélectivement le matériau auxiliaire (14).

43. Procédé selon la revendication 42,
dans lequel on utilise comme matériau auxiliaire (14) un matériau à base de métal, polymère et/ou verre.

44. Procédé selon l'une quelconque des revendications 11 à 30,
dans lequel

- l'application de la couche d'adhérence et d'imprégnation (6) selon l'étape (c) du processus se limite seulement à la surface de la dernière couche externe,
- avant l'étape (d) du processus on recouvre complètement les creux des mésas (10) avec une couche anti-imprégnation (16),
- l'application du substrat porteur (7) selon l'étape (d) du processus a lieu de façon correspondante seulement sur la couche d'adhérence et d'imprégnation (6) et est arrêtée avant la fusion d'îlots de substrat porteur (71) voisins,

- on surmoule entièrement avec un matériau auxiliaire (14) l'ensemble de la structure au-dessus du substrat de croissance (1) y compris les îlots de substrat porteur (71) libres faisant saillie et les creux de mésas (10) et

- on effectue dans l'étape (h) ou (g) du processus l'isolement des puces en appliquant un film de support (15) au-dessus des contacts électriques (8) sur la couche de semi-conducteur (2) et en éliminant sélectivement le matériau auxiliaire (14).

45. Procédé selon la revendication 11, dans lequel le vernis photosensible est structuré de telle sorte qu'au moins un moule négatif d'un élément structural vertical est prévu au-dessous du centre de la couche de semi-conducteur (2).

# FIG 1

# FIG 2A

# FIG 2B

## FIG 3A

2
3
4
5
6
25
26

7

24

## FIG 3B

25
26

7

24

19

## FIG 3C

19

# FIG 4

# FIG 5

## FIG 6A

## FIG 6B

## FIG 7A

## FIG 7B

## FIG 7C

# FIG 7D

# FIG 7E

## FIG 7F

## FIG 7G

## FIG 8

## FIG 9A

## FIG 9B

## FIG 9C

# FIG 9D

# FIG 9E

# FIG 9F

## FIG 10A

## FIG 10B

## FIG 10C

## FIG 10D

71

10

1

## FIG 10E

14

2

1

FIG 10F

FIG 10G

## FIG 11A

## FIG 11B

FIG 11C

FIG 11D

FIG 12A

FIG 12B

## FIG 13A

## FIG 13B

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente

- DE 10040448 A1
- DE 10245631333

### In der Beschreibung aufgeführte Nicht-Patentliteratur

- **WADA ET.** *Jpn. Appl. Phys.,* 1992, vol. 31, L78-L81